(19) Europäisches Patentamt
European Patent Office
Office européen des brevets

(11) EP 3 511 360 A1

(12) # EUROPEAN PATENT APPLICATION
published in accordance with Art. 153(4) EPC

(43) Date of publication:
**17.07.2019 Bulletin 2019/29**

(21) Application number: **17848699.9**

(22) Date of filing: **04.09.2017**

(51) Int Cl.:
***C08G 77/04*** (2006.01) ***C08G 77/44*** (2006.01)
***C08K 3/00*** (2018.01) ***C08L 83/04*** (2006.01)
***C08L 83/06*** (2006.01) ***H01L 23/29*** (2006.01)
***H01L 23/31*** (2006.01) ***H01L 33/50*** (2010.01)
***H01L 33/56*** (2010.01) ***H01S 5/022*** (2006.01)

(86) International application number:
**PCT/JP2017/031731**

(87) International publication number:
**WO 2018/047759 (15.03.2018 Gazette 2018/11)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **07.09.2016 JP 2016175094**

(71) Applicant: **Sumitomo Chemical Co., Ltd.**
**Tokyo 104-8260 (JP)**

(72) Inventors:
- **DOI, Atsunori**
  **Tsukuba-shi**
  **Ibaraki 300-3294 (JP)**
- **NISHIDA, Toshihiko**
  **Tsukuba-shi**
  **Ibaraki 300-3294 (JP)**
- **MASUI, Kentaro**
  **Osaka-shi**
  **Osaka 554-8558 (JP)**

(74) Representative: **Winter, Brandl, Fürniss, Hübner, Röss, Kaiser, Polte - Partnerschaft mbB**
**Patent- und Rechtsanwaltskanzlei**
**Alois-Steinecker-Strasse 22**
**85354 Freising (DE)**

(54) **CURED PRODUCT, WAVELENGTH CONVERSION SHEET, LIGHT-EMITTING DEVICE, SEALING MEMBER, AND SEMICONDUCTOR LIGHT-EMITTING DEVICE**

(57) Provided is a cured product having high hardness, high crack resistance and high heat resistance.

A cured product which contains a condensed silicone resin cured product and satisfies (1) and (2).

(1) In a solid state $^{29}$Si-nuclear magnetic resonance spectrum of a condensed silicone resin cured product, there is a peak assigned to silicon atoms of a T unit (silicon atoms bonded to three oxygen atoms).

(2) In a Kratky Plot (a graph plotting measured values of small-angle X-ray scattering of the condensed silicone resin cured product, with a wavenumber of an X-ray as a horizontal axis, and with the value obtained by multiplying a scattering intensity obtained by subtracting atmospheric scattering from a measured scattering intensity to be measured, by the square of the wavenumber of the X-ray as a vertical axis), from a wavenumber $q_{Max}$ of a maximum peak position in the range of wavenumbers of 0.01 to 0.17 Å$^{-1}$ of the X-ray, a parameter $d_{Max}$ obtained by formula (A) is 170 Å or less.

$$d_{Max} = 2\pi / q_{Max} \quad \ldots (A)$$

EP 3 511 360 A1

**Description**

TECHNICAL FIELD

The present invention relates to a cured product, a wavelength conversion sheet, a light-emitting device, a sealing member, and a semiconductor light-emitting device.

BACKGROUND ART

In recent years, a light-emitting device using a semiconductor laser (LD, Laser Diode) or a light emitting diode (LED) has been studied.

A semiconductor laser can maintain high conversion efficiency homogeneous in a high current density region. Further, it is possible to downsize a device by separating a light emitting portion and an excitation portion of the semiconductor laser. Therefore, it is expected to use a semiconductor laser for a lighting device.

With the progress of recent technology development, luminance of light-emitting diodes has been advanced.

As a transparent material used for a light-emitting device, a silicone resin cured product is known. For example, Patent Document 1 describes that a cured product of a polymerizable silicone resin is used as a matrix material of a phosphor sheet of an LED. The silicone resin cured product is not only excellent in light transmissivity but also excellent in heat resistance and UV resistance. Therefore, a member using a silicone resin cured product as a forming material is preferable because it hardly deteriorates homogeneous when used for a light-emitting device used for a long time.

PRIOR ART DOCUMENT

PATENT DOCUMENT

Patent Document 1: JP-A-2013-1792

SUMMARY OF THE INVENTION

PROBLEMS TO BE SOLVED BY THE INVENTION

A member using a high hardness silicone resin cured product as a forming material has an advantage that it is hardly scratched. On the other hand, the high hardness silicone resin cured product has a disadvantage that the yield tends to be lowered since cracks tend to occur during curing. Also, the high hardness silicone resin cured product has a disadvantage that cracks due to thermal stress and the like tend to occur at the time of use. Therefore, a silicone resin cured product which is a high hardness silicone resin cured product, hardly causing cracks upon curing and hardly causing cracks upon heating, has been required.

In the following description, the "property of hardly causing cracks upon curing" may be referred to as "crack resistance" in some cases. Further, the "property of hardly causing cracks upon heating" may be referred to as "heat resistance" in some cases.

In a light-emitting device using a semiconductor laser or a UV-LED, light with high energy density may be irradiated on members. Further, in a light-emitting device using a high luminance LED, members may be exposed to high temperature due to heat generation during use. Therefore, high heat resistance is required for the members used for these light-emitting devices.

The present invention has been made in view of such circumstances, and an object thereof is to provide a cured product having high hardness, high crack resistance, and high heat resistance. Another object of the present invention is to provide a wavelength conversion sheet using the cured product as a forming material, a light-emitting device, a sealing member, and a semiconductor light-emitting device.

MEANS FOR SOLVING THE PROBLEMS

In order to solve the above problem, the present invention provides the following [1] to [13].

[1] A cured product containing a condensed silicone resin cured product and satisfying the following (1) and (2).

(1) In a solid state $^{29}$Si-nuclear magnetic resonance spectrum of the condensed silicone resin cured product, there is a peak assigned to silicon atoms of a T unit, wherein the silicon atoms of a T unit mean a silicon atom bonded to three oxygen atoms.

(2) In the following Kratky Plot, from a wavenumber $q_{Max}$ ($Å^{-1}$) of a maximum peak position in the range of wavenumbers of 0.01 $Å^{-1}$ to 0.17 $Å^{-1}$ of X-rays used for measurement of small-angle X-ray scattering, a parameter $d_{Max}$ obtained by the following formula (A) is 170 Å or less.

$$d_{Max} = 2\pi / q_{Max} \quad \ldots (A)$$

wherein the Kratky Plot means,
a graph obtained by plotting measured values of small-angle X-ray scattering of the condensed silicone resin cured product,
with the wavenumber of the X-ray used for measurement of small-angle X-ray scattering as a horizontal axis, and with the value obtained by multiplying a scattering intensity obtained by subtracting atmospheric scattering from a measured scattering intensity to be measured by small-angle X-ray scattering, by the square of the wavenumber (unit: $Å^{-1}$) of the X-ray used for measurement of small-angle X-ray scattering as a vertical axis.

[2] The cured product according to [1], wherein the ratio of the silicon atoms of a T unit to all silicon atoms contained in the condensed silicone resin cured product is 50% by mole or more.
[3] The cured product according to [2], wherein the ratio of the T3 silicon atoms to all silicon atoms contained in the condensed silicone resin cured product is 50% by mole or more,
wherein the T3 silicon atoms mean silicon atoms in which all three oxygen atoms are bonded to other silicon atoms, among the silicon atoms of a T unit.
[4] The cured product according to any of [1] to [3], wherein the condensed silicone resin cured product contains a structural unit represented by formula (A1), formula (A1'), formula (A2) or formula (A3),

[Chemical Formula 1]

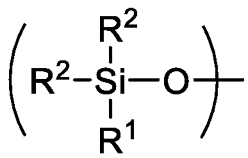 (A1) 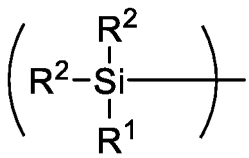 (A1')

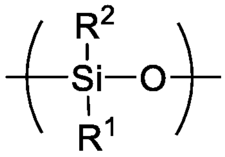 (A2) 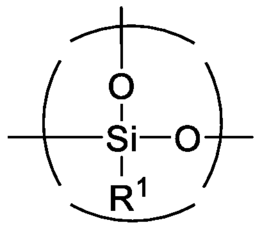 (A3)

in the formulas (A1), (A1'), (A2) and (A3),

$R^1$s represent alkyl groups having 1 to 10 carbon atoms or aryl groups having 6 to 10 carbon atoms;
$R^2$s represent alkoxy groups having 1 to 4 carbon atoms or hydroxyl groups; and
a plurality of $R^1$s and $R^2$s each may be the same or different.

[5] The cured product according to [4], wherein the $R^1$s are methyl groups, and
the $R^2$s are alkoxy groups having 1 to 3 carbon atoms or hydroxyl groups, and a plurality of $R^2$s may be the same or different.
[6] The cured product according to any one of [1] to [5], wherein a filler is dispersed in the condensed silicone resin cured product.
[7] The cured product according to [6], wherein the filler is a wavelength conversion material.
[8] The cured product according to [7], wherein the wavelength conversion material is a phosphor.
[9] A wavelength conversion sheet containing the cured product as defined in [7] or [8] as a forming material.
[10] A light-emitting device having a light source for emitting light, and
the wavelength conversion sheet as defined in [9] arranged at a position where light emitted from the light source is made incident.

[11] A sealing member using the cured product as defined in any of [1] to [8] as a forming material.
[12] A semiconductor light-emitting device having
a substrate,
a semiconductor light emitting element disposed on the substrate, and
a sealing member for sealing at least a part of the semiconductor light emitting element, wherein
the sealing member is the sealing member as defined in [11].
[13] The semiconductor light-emitting device according to [12], wherein the emission wavelength of the semiconductor light emitting element is 400 nm or less.

EFFECT OF THE INVENTION

According to the present invention, it is possible to provide a cured product having high hardness, high crack resistance and high heat resistance. Further, it is possible to provide a wavelength conversion sheet using the cured product as a forming material, a light-emitting device, a sealing member, and a semiconductor light-emitting device.

BRIEF DESCRIPTION OF THE DRAWINGS

Fig. 1 is a schematic diagram showing a polymerization state of a cured product of the present embodiment.
Fig. 2 is a schematic diagram showing a wavelength conversion sheet of the present embodiment.
Fig. 3 is a schematic diagram showing a light-emitting device of the present embodiment.
Fig. 4 is a schematic diagram showing a light-emitting device of the present embodiment.
Fig. 5 is a schematic diagram showing a light-emitting device of the present embodiment.
Fig. 6 is a cross-sectional diagram of a semiconductor light-emitting device of the present embodiment.
Fig. 7 is a Kratky Plot created for cured products of Examples and Comparative Examples.

MODE FOR CARRYING OUT THE INVENTION

Hereinafter, embodiments of the present invention will be described.
The structural unit contained in a silicone resin is preferably contained in the silicone resin as a repeating unit.

<Cured Product>

The cured product of the present invention contains a condensed silicone resin cured product and satisfies the following (1) and (2).

(1) In a solid state $^{29}$Si-nuclear magnetic resonance spectrum of the condensed silicone resin cured product, there is a peak assigned to silicon atoms of a T unit. Here, the silicon atoms of a T unit mean silicon atoms bonded to three oxygen atoms.
(2) In the following Kratky Plot, from a wavenumber $q_{Max}$ (Å$^{-1}$) of a maximum peak position in the range of wavenumbers of 0.01 Å$^{-1}$ to 0.17 Å$^{-1}$ of X-rays used for measurement of small-angle X-ray scattering, a parameter $d_{Max}$ obtained by the following formula (A) is 170 Å or less.

$$d_{Max} = 2\pi/q_{Max} \quad ...(A)$$

Here, the Kratky Plot means,
a graph obtained by plotting measured values of small-angle X-ray scattering of the condensed silicone resin cured product,
with the wavenumber of the X-ray used for measurement of small-angle X-ray scattering as a horizontal axis, and
with the value obtained by multiplying a scattering intensity obtained by subtracting atmospheric scattering from a measured scattering intensity to be measured by small-angle X-ray scattering, by the square of the wavenumber (unit: Å$^{-1}$) of the X-ray used for measurement of small-angle X-ray scattering as a vertical axis.

(Condensed Silicone Resin Cured Product)

A condensed silicone resin is used as a raw material for the condensed silicone resin cured product contained in the cured product of the present embodiment. One type of condensed silicone resin may be used alone, or two or more types may be used.

The condensed silicone resin refers to a resin polycondensed by dealcoholization reaction or dehydration reaction of a hydroxyl group bonded to a silicon atom and an alkoxy group or hydroxyl group bonded to another silicon atom.

The condensed silicone resin which is a raw material for the condensed silicone resin cured product contained in the cured product of the present embodiment contains a structural unit represented by the following formula (A3). Also, the condensed silicone resin preferably further contains one or more selected from the group consisting of a structural unit represented by the formula (A1), a structural unit represented by the formula (A1') and a structural unit represented by the formula (A2), and more preferably further contains all of the structural unit represented by the formula (A1), the structural unit represented by the formula (A1') and the structural unit represented by the formula (A2).

[Chemical Formula 2]

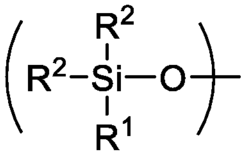
(A1)

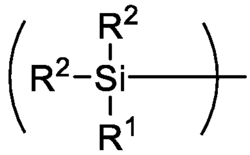
(A1')

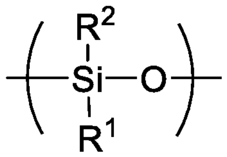
(A2)

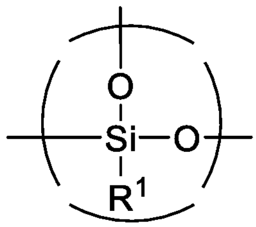
(A3)

In the formulas (A1), (A1'), (A2) and (A3),

$R^1$s represent alkyl groups having 1 to 10 carbon atoms or aryl groups having 6 to 10 carbon atoms;
$R^2$s represent alkoxy groups having 1 to 4 carbon atoms or hydroxyl groups; and
a plurality of $R^1$s and $R^2$s each may be the same or different.

In the present specification, a structural unit containing a silicon atom bonded to three oxygen atoms is referred to as "T unit".

Also, a structural unit containing a silicon atom in which all the three oxygen atoms are bonded to other silicon atoms is referred to as "T3 unit".

Further, a structural unit containing a silicon atom in which two oxygen atoms among the three oxygen atoms are bonded to other silicon atoms is referred to as "T2 unit".

Moreover, a structural unit containing a silicon atom in which one oxygen atom among the three oxygen atoms is bonded to another silicon atom is referred to as "T1 unit".

That is, the T unit means the T1 unit, T2 unit and T3 unit.

In the present specification, a structural unit containing a silicon atom bonded to two oxygen atoms is referred to as "D unit". A structural unit containing a silicon atom bonded to one oxygen atom is referred to as "M unit".

The structural unit represented by the formula (A3) contains three oxygen atoms bonded to other silicon atoms and a silicon atom bonded to $R^1$. Since $R^1$ is an alkyl group having 1 to 10 carbon atoms or an aryl group having 6 to 10 carbon atoms, the structural unit represented by the formula (A3) is a T3 unit.

The structural unit represented by the formula (A2) contains two oxygen atoms bonded to other silicon atoms, and a silicon atom bonded to $R^1$ and $R^2$. Since $R^2$ is an alkoxy group having 1 to 4 carbon atoms or a hydroxyl group, the structural unit represented by the formula (A2) is a T2 unit.

The structural unit represented by the formula (A1) contains one oxygen atom bonded to another silicon atom, and a silicon atom bonded to $R^1$ and two $R^2$s. Since $R^1$ is an alkyl group having 1 to 10 carbon atoms or an aryl group having 6 to 10 carbon atoms and $R^2$ is an alkoxy group having 1 to 4 carbon atoms or a hydroxyl group, the structural unit represented by the formula (A1) is a T1 unit.

The structural unit represented by the formula (A1') contains a silicon atom bonded to $R^1$ and two $R^2$s, and the silicon atom is bonded to an oxygen atom bonded to a silicon atom in another structural unit. Since $R^1$ is an alkyl group having 1 to 10 carbon atoms or an aryl group having 6 to 10 carbon atoms and $R^2$ is an alkoxy group having 1 to 4 carbon atoms or a hydroxyl group, the structural unit represented by the formula (A1') is a T1 unit.

The structural unit represented by the formula (A1) and the structural unit represented by the formula (A1') constitute an end of an organopolysiloxane chain contained in a condensed silicone resin. Further, the structural unit represented by the formula (A3) constitutes a branched chain structure of the organopolysiloxane chain contained in the condensed silicone resin. That is, the structural unit represented by the formula (A3) forms a part of a network structure and a ring structure in the condensed silicone resin.

In the present specification, the silicon atom contained in the T3 unit is referred to as "T3 silicon atom". Also, the silicon atom contained in the T2 unit is referred to as "T2 silicon atom". Moreover, the silicon atom contained in the T1 unit is referred to as "T1 silicon atom".

The total content of the T1 unit, T2 unit and T3 unit is preferably 50% by mole or more, to the total content of all structural units of the condensed silicone resin. In other words, the total content of the T1 silicon atoms, T2 silicon atoms and T3 silicon atoms is preferably 50% by mole or more, to the total content of all silicon atoms of the condensed silicone resin. Further, the total content of the T1 silicon atoms, T2 silicon atoms and T3 silicon atoms is more preferably 60% by mole or more, further preferably 70% by mole or more, still more preferably 80% by mole or more, and particularly preferably 90% by mole or more, to the total content of all silicon atoms contained in the condensed silicone resin.

The content of the D unit is preferably 30% by mole or less, more preferably 20% by mole or less, further preferably 10% by mole or less, still more preferably 5% by mole or less, and particularly preferably 4% by mole or less, to the total content of all structural units of the condensed silicone resin.

The total content of the T1 unit, T2 unit and T3 unit can be obtained by dividing the total area of signals assigned as T1 silicon atoms, T2 silicon atoms and T3 silicon atoms by the total area of signals of all silicon atoms obtained in the solid state $^{29}$Si-NMR measurement.

The content of the T3 unit is preferably 50% by mole or more, to the total content of all structural units of the condensed silicone resin. In other words, the content of the T3 silicon atoms is preferably 50% by mole or more, to the total content of all silicon atoms of the condensed silicone resin. Further, the content of the T3 silicon atoms is more preferably 60% by mole or more, and further preferably 70% by mole or more, to the total content of all silicon atoms of the condensed silicone resin.

The content of the T3 silicon atoms can be obtained by dividing the area of the signal assigned as the T3 silicon atoms by the total area of signals of all silicon atoms determined in the solid state $^{29}$Si-NMR measurement. The content of silicon atoms other than the T3 silicon atoms can also be determined in the same manner.

The alkyl group having 1 to 10 carbon atoms represented by $R^1$ may be a linear alkyl group, a branched chain alkyl group, or an alkyl group having a cyclic structure. Among them, a linear or branched alkyl group is preferable, and a linear alkyl group is more preferable.

In the alkyl group having 1 to 10 carbon atoms represented by $R^1$, one or more hydrogen atoms constituting the alkyl group may be substituted with other functional groups. Examples of the substituent of the alkyl group include aryl groups having 6 to 10 carbon atoms such as a phenyl group and naphthyl group, and a phenyl group is preferable.

Examples of the alkyl group having 1 to 10 carbon atoms represented by $R^1$ include unsubstituted alkyl groups such as a methyl group, ethyl group, n-propyl group, isopropyl group, n-butyl group, isobutyl group, tert-butyl group, n-pentyl group, neopentyl group, hexyl group, octyl group, nonyl group and decyl group, and aralkyl groups such as a phenylmethyl group, phenylethyl group, and phenylpropyl group. Among them, a methyl group, ethyl group, n-propyl group or n-butyl group is preferable, a methyl group, ethyl group or isopropyl group is more preferable, and a methyl group is further preferable.

In the aryl group having 6 to 10 carbon atoms represented by $R^1$, one or more hydrogen atoms constituting the aryl group may be substituted with other functional group. Examples of the substituent of the aryl group include alkyl groups having 1 to 10 carbon atoms such as a methyl group, ethyl group, propyl group, and butyl group.

Examples of the aryl group having 6 to 10 carbon atoms represented by $R^1$ include unsubstituted aryl groups such as a phenyl group and naphthyl group, and alkylaryl groups such as a methylphenyl group, ethylphenyl group and propylphenyl group. Among them, a phenyl group is preferable.

$R^1$ is preferably an alkyl group, more preferably a methyl group, ethyl group or isopropyl group, and further preferably a methyl group.

The alkoxy group having 1 to 4 carbon atoms represented by $R^2$ may be a linear alkoxy group, a branched chain alkoxy group, or an alkoxy group having a cyclic structure. Among them, a linear or branched alkoxy group is preferable, and a linear alkoxy group is more preferable.

As the alkoxy group having 1 to 4 carbon atoms represented by $R^2$, for example, a methoxy group, ethoxy group, n-propoxy group, isopropoxy group, n-butoxy group, isobutoxy group or tert-butoxy group is preferable, and a methoxy group, ethoxy group or isopropoxy group is more preferable.

As $R^2$, a methoxy group, ethoxy group, isopropoxy group or hydroxyl group is preferable.

The condensed silicone resin which is a raw material for the condensed silicone resin cured product contained in the cured product of the present embodiment may further contain a structural unit represented by the following formula (C1), formula (C1'), formula (C2), formula (C3) or formula (C4).

[Chemical Formula 3]

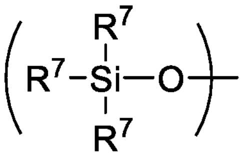 (C1) 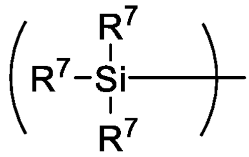 (C1')

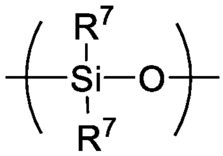 (C2) 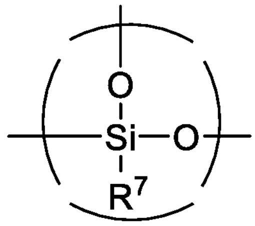 (C3)

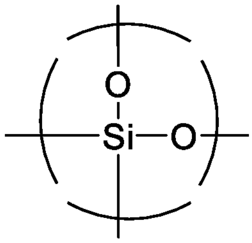 (C4)

In the formulas (C1), (C1'), (C2), (C3) and (C4), $R^7$ represents an alkoxy group having 1 to 4 carbon atoms or a hydroxyl group; and a plurality of $R^7$s may be the same or different.

In the present specification, a structural unit containing a silicon atom bonded to four oxygen atoms is referred to as "Q unit".

Also, a structural unit containing a silicon atom in which one oxygen atom among the four oxygen atoms is bonded to another silicon atom is referred to as "Q1 unit". The structural unit represented by the formula (C1) and the structural unit represented by the formula (C1') are Q1 units.

Moreover, a structural unit containing a silicon atom in which two oxygen atoms among the four oxygen atoms are bonded to other silicon atoms is referred to as "Q2 unit". The structural unit represented by the formula (C2) is a Q2 unit.

Further, a structural unit containing a silicon atom in which three oxygen atoms among the four oxygen atoms are bonded to other silicon atoms is referred to as "Q3 unit". The structural unit represented by the formula (C3) is a Q3 unit.

Furthermore, a structural unit containing a silicon atom in which all the four oxygen atoms are bonded to other silicon atoms is referred to as "Q4 unit". The structural unit represented by the formula (C4) is a Q4 unit.

That is, the Q unit means Q1 unit, Q2 unit, Q3 unit, and Q4 unit.

The specific gravity of the condensed silicone resin cured product contained in the cured product of the present embodiment is preferably 1.20 to 1.35. The specific gravity of the condensed silicone resin cured product can be appropriately adjusted by controlling the content ratio of the D, T and Q units.

(Kratky Plot)

As a result of intensive studies by the inventors, measurement of small-angle X-ray scattering was performed for a condensed silicone resin cured product, and it was found that specific parameters calculated from measured values of small-angle X-ray scattering correlate with crack resistance and hardness of the cured product (that is, mechanical properties of the cured product). That is, it was found that a cured product whose specific parameters satisfy a predetermined requirement has excellent hardness and excellent crack resistance. In addition, it was found that the cured product whose specific parameters satisfy a predetermined requirement retains strength and transparency (that is, it has excellent heat resistance) even after being exposed to high temperature.

Specifically, in the Kratky Plot, a cured product in which, from a wavenumber $q_{Max}$ ($Å^{-1}$) of a maximum peak

position in the range of wavenumbers of 0.01 Å$^{-1}$ to 0.17 Å$^{-1}$ of X-rays used for measurement of small-angle X-ray scattering, a parameter $d_{Max}$ obtained by the following formula (A) is 170 Å or less, has excellent hardness, crack resistance and heat resistance.

$$d_{Max} = 2\pi/q_{Max} \quad \ldots(A)$$

Small-angle X-ray scattering measurement can be conducted with a small-angle X-ray scattering instrument equipped with a two-dimensional detector. Examples of such instrument include NanoSTAR (instrument name, manufactured by Bruker AXS).

X-rays are generated at an output of 50 kV and 100 mA using, for example, a rotating anticathode X-ray generator with a Cu target. Then, the generated X-rays are irradiated on the cured product.

X-rays are irradiated on the cured product (sample) through an X-ray optical system composed of, for example, a cross-coupled Goebel mirror and three pinhole slits (with slit pore sizes of 500 μmφ, 150 μmφ, 500 μmφ from the X-ray generator side). Then, X-rays scattered by the cured product are detected using a two-dimensional detector (two-dimensional Multi Wire detector, Hi-STAR).

The length from the sample to the detector can be set to, for example, 106 cm, and the size of the direct-beam stopper can be set to, for example, 2 mmφ. The degree of vacuum in the instrument is set to, for example, 40 Pa or less.

Calibration of a scattering angle 2θ and a direct-beam position is carried out, for example, using respective peaks of a first order (2θ = 1.513°) and a second order (2θ = 3.027°) of silver behenate. In this case, the range of measurable scattering angle 2θ is 0.08 to 3°.

A two-dimensional scattering image obtained by the detection is analyzed, for example, using an analysis software (SAXS Ver. 4.1.29) manufactured by Bruker AXS to obtain a small-angle X-ray small-angle scattering spectrum. In the obtained small-angle X-ray scattering spectrum, the horizontal axis is the wavenumber (unit: Å$^{-1}$) of X-rays, and the vertical axis is the measured scattering intensity.

Also, a blank measurement (atmospheric scattering) in a state where no sample is installed can also be performed in the same manner as described above.

A graph plotting measured values obtained in each measurement is created,
with the wavenumber of the X-ray used for measurement of small-angle X-ray scattering of the condensed silicone resin cured product as a horizontal axis, and with the value (spectrum) obtained by multiplying a scattering intensity obtained by subtracting atmospheric scattering from a measured scattering intensity to be measured by small-angle X-ray scattering of the condensed silicone resin cured product, by the square of the wavenumber (unit: Å$^{-1}$) of the X-ray used for measurement of small-angle X-ray scattering as a vertical axis. The obtained graph is Kratky Plot.

In the Kratky Plot, the parameter $d_{Max}$ is obtained from the formula (A), from a wavenumber $q_{Max}$ (Å$^{-1}$) of a maximum peak position in the range of wavenumbers of 0.01 Å$^{-1}$ to 0.17 Å$^{-1}$ of X-rays used for measurement of small-angle X-ray scattering.

In small-angle X-ray scattering, in general, electron density contrast in a substance derived from the shape of a particle and the sparseness and density of crosslinking points is reflected on a scattering profile. When a Kratky Plot is created in an analysis of a higher order structure of the cured product, a peak structure is formed at a position corresponding to the size of sparseness and density in the cured product, so that the spread (inhomogeneity) of sparseness and density in the cured product can be evaluated. That is, the parameter $d_{Max}$ can be used as an index showing inhomogeneity of sparseness and density in the cured product. The smaller parameter $d_{Max}$ shows the cured product having internal structure more homogeneous.

It is considered that the position of the maximum peak in a Kratky Plot varies due to the effect of the polymerization state of the cured product.

The condensed silicone resin cured product contained in the cured product of the present embodiment is obtained by polycondensing a composition containing a condensed silicone resin having a functional group as described above. In the polymerization reaction at this time, the "inhomogeneous" state is formed, which does not proceed homogeneously in the entire composition but has a region where the polymerization reaction proceeds well and a region where the polymerization reaction does not proceed much. This tendency is particularly remarkable in a composition in which two or more different types of silicone resins are blended.

This is probably because the raw material of the cured product is not a monomer but a silicone resin or oligomer having a certain molecular weight, and the free movement of the silicone resin or oligomer in the composition is restricted. Since the polymerization reaction is a reaction in a state in which molecular migration is regulated, an inhomogeneous state where the reaction proceeds at a position where the polymerization reaction is possible, whereas the reaction does not proceed for a functional group having no reaction point in the periphery is formed in the cured product.

Fig. 1 is a schematic diagram showing the polymerization state described above, and shows the distribution

of the T3 silicon atoms contained in the silicone resin. In Fig. 1, the color shading indicates the amount of the T3 silicon atoms. The light colored portion indicates a region where the polymerization reaction does not proceed much and that the number of T3 silicon atoms is low, and the dark colored portion indicates a region where the polymerization reaction proceeds and the number of T3 silicon atoms is high. Therefore, Fig. 1(b) shows a state in which the polymerization reaction has proceeded from Fig. 1(a).

That is, when a silicone resin 10 (Fig. 1(a)) which is a starting material is polymerized, an "inhomogeneous" state in which a region where the polymerization reaction proceeds well (indicated by reference sign A in the drawing) and a region where the polymerization reaction does not proceed much (indicated by reference sign B in the drawing) are mixed is formed. Spread of sparseness and density in the cured product is derived from such inhomogeneous state. Hereinafter, the spread of sparseness and density in the cured product may be referred to as "inhomogeneity" of the cured product. This "inhomogeneity" can be quantitatively evaluated by the above-described parameter $d_{Max}$.

In the small-angle X-ray scattering, a scattering profile is obtained, based on the electron density contrast between region A and region B. The parameter $d_{Max}$ obtained from the above-described Kratky Plot corresponds to the average distance of the center-to-center distance d between arbitrarily selected certain region A1 and region A2 closest to the region A1, schematically shown in Fig. 1(b). In Fig. 1(b), the center of the region A1 is indicated by reference sign P1, and the center of the region A2 is indicated by reference sign P2.

The center of the region corresponds to the center of gravity position of each region. That is, P1 which is the center of the region A1 and P1 which is the center of the region A2 correspond to the centers of gravity of the regions A1 and A2, respectively.

According to the studies by the inventors, it was revealed that the cured product having a parameter $d_{Max}$ of 170 Å or less has high hardness, high crack resistance and high heat resistance.

The condensed silicone resin cured product contained in the cured product of the present embodiment preferably has a parameter $d_{Max}$ of 40 Å or more and 170 Å or less. A condensed silicone resin cured product having the parameter $d_{Max}$ within this range satisfies high hardness (for example, 70 or more in Shore D hardness), high crack resistance, and high heat resistance, so that it is suitable for device application.

In the present specification, the hardness measured using a type D durometer (rubber · plastic hardness tester) at a descending speed of 1 mm/sec was defined as the Shore D hardness.

(Method of controlling parameter $d_{Max}$)

A method of controlling the parameter $d_{Max}$ will be described.

The parameter $d_{Max}$ can be controlled by (i) combination ratio of the silicone resin and (ii) curing conditions of the silicone resin. First, a method of controlling $d_{Max}$ according to (i) combination ratio of the silicone will be described.

(i) Control by combination ratio of silicone resin

The condensed silicone resin cured product contained in the cured product of the present embodiment is preferably a cured product obtained by heating and curing a condensed silicone resin obtained by blending a silicone resin (hereinafter referred to as "silicone resin A") as a main component and an oligomer component to be described later. At this time, the parameter $d_{Max}$ can be controlled by adjusting the type and combination ratio of the silicone resin A and the oligomer component as raw materials.

The silicone resin A is a material containing many crosslinking points (branched structures) forming a network structure. The oligomer component has a linear chain structure such as T2 unit and D unit structure, and is a material having fewer crosslinking points than the silicone resin A.

Hereinafter, the silicone resin A and the oligomer component will be described.

<<Silicone Resin A>>

The silicone resin A contains the structural unit represented by the formula (A3). Further, the silicone resin A preferably further contains one or more structural units selected from the group consisting of the structural unit represented by the formula (A1), the structural unit represented by the formula (A1'), and the structural unit represented by the formula (A2).

In the silicone resin A, the total content of the T1 unit, T2 unit and T3 unit is usually 70% by mole or more, to the total content of all structural units of the silicone resin A.

In the silicone resin A, the content of the T3 unit is usually 60% by mole or more and 90% by mole or less, to the total content of all structural units of the silicone resin A.

The polystyrene equivalent weight average molecular weight of the silicone resin A is usually 1500 or more and 8000 or less.

In the silicone resin A, the total content of the T1 unit, T2 unit and T3 unit is preferably 80% by mole or more, more preferably 90% by mole or more, and further preferably 95% by mole or more, to the total content of all structural units of the silicone resin A.

In the silicone resin A, the content of the T3 unit is preferably 65% or more and 90% or less, and more preferably 70% or more and 85% or less, to the total content of all structural units of the silicone resin A.

The polystyrene equivalent weight average molecular weight of the silicone resin A is preferably from 1500 or more to 7000 or less, and more preferably from 2000 or more to 5000 or less.

As the silicone resin A, a commercially available silicone resin can be used.

The silicone resin A preferably has a silanol group (Si-OH). In the silicone resin A, a silicon atom having a silanol group is preferably 1 to 30% by mole, more preferably 5 to 27% by mole, and further preferably 10 to 25% by mole, to all silicon atoms contained in the silicone resin A. In the silicone resin A, when the content of the silicon atoms having a silanol group is within the above range, curing process speed falls within an appropriate range, and by combining with structure control by the curing conditions of the silicone resin described later, it is possible to effectively control mechanical properties such as hardness and strength of the cured product.

Further, in the silicone resin A, a silicon atom having an alkoxy group is preferably more than 0% by mole and 20% by mole or less, more preferably more than 0% by mole and 10% by mole or less, and further preferably 1% by mole or more and 10% by mole or less, to all silicon atoms contained in the silicone resin A. In the silicone resin A, when the content of the silicon atoms having an alkoxy group is within the above range, fluidity of the silicone resin composition obtained by dissolving the silicone resin in the solvent is within an appropriate range, thus handling properties of the silicone resin composition is improved.

The silicone resin A can be synthesized using an organosilicon compound having a functional group capable of forming a siloxane bond as a starting material. Here, examples of the "functional group capable of forming a siloxane bond" include a halogen atom, a hydroxyl group, and an alkoxy group. Examples of the organosilicon compound corresponding to the structural unit represented by the formula (A3) include organotrihalosilanes, organotrialkoxysilanes, and the like. The silicone resin A can be synthesized by reacting an organosilicon compound as the starting material in a ratio corresponding to the abundance ratio of each structural unit by a hydrolysis condensation method, in the presence of an acid such as hydrochloric acid or a base such as sodium hydroxide. By appropriately selecting the organosilicon compound as the starting material, the abundance ratio of T3 silicon atoms contained in the silicone resin A can be adjusted.

The content of the silicone resin A contained in the condensed silicone resin is preferably 60% by mass to 100% by mass, and more preferably 70% by mass to 95% by mass, to the total content of all silicone resins contained in the condensed silicone resin.

<<Oligomer Component>>

In a case where the condensed silicone resin contains the silicone resin A and an oligomer having a content of the T3 unit less than the silicone resin A and having a straight chain structure, a region where polymerization reaction is likely to occur and a region where polymerization reaction hardly occurs are generated. Therefore, inhomogeneity tends to occur during the polymerization reaction.

[Oligomer B]

Examples of the oligomer component include oligomers containing a structural unit represented by the following formula (B1), formula (B1'), formula (B2) or formula (B3).

[Chemical Formula 4]

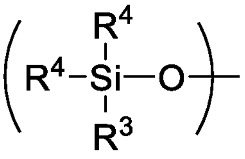 (B1) 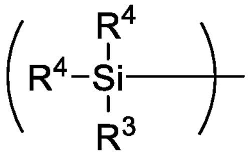 (B1')

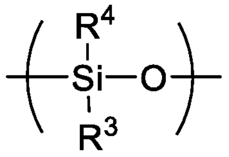 (B2) 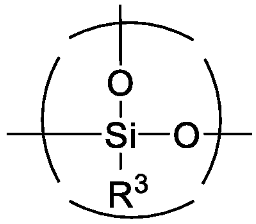 (B3)

In the formulas (B1), (B1'), (B2) and (B3),

$R^3$ represents an alkyl group having 1 to 10 carbon atoms or an aryl group having 6 to 10 carbon atoms;
$R^4$ represents an alkyl group having 1 to 10 carbon atoms, an aryl group having 6 to 10 carbon atoms, an alkoxy group having 1 to 4 carbon atoms or a hydroxyl group; and
a plurality of $R^3$s and $R^4$s each may be the same or different.

The polystyrene equivalent weight average molecular weight of the oligomer containing the structural units represented by the formula (B1), the formula (B1'), the formula (B2) and the formula (B3) is preferably 1000 to 10000, more preferably 2000 to 8000, and further preferably 3000 to 6000.

In the following description, an oligomer component containing the structural units represented by the formula (B1), the formula (B1'), the formula (B2) and the formula (B3) and having a polystyrene equivalent weight average molecular weight of 1000 to 10000 is referred to as "oligomer B".

The oligomer B is preferably (a) an oligomer containing a T2 unit or (b) an oligomer containing a D unit, and more preferably an oligomer satisfying (a) and (b), that is, (c) an oligomer containing a T2 unit and a D unit.

(a) Oligomer containing T2 unit

As the oligomer containing a T2 unit (a), one having a content of the structural unit represented by the formula (B2) contained in the first oligomer in which $R^4$ is an alkoxy group having 1 to 4 carbon atoms or a hydroxyl group, that is, a content of the T2 unit, of 30 to 60% by mole is preferable, and of 40 to 55% by mole is more preferable.

In the case where the oligomer B is an oligomer containing a T2 unit (a), when the content of the T2 unit is within the above-described range, the condensed silicone resin exhibits good curing reactivity during thermal curing while securing solubility of the silicone resin A and the oligomer B.

(b) Oligomer containing D unit

As the oligomer containing a D unit (b), a silicone resin containing a structural unit represented by the formula (B1), the formula (B1'), the formula (B2) or the formula (B3) in which the average composition formula is represented by the following formula (I) is preferable.

$$(R^5)_nSi(OR^6)_mO_{(4-n-m)/2} \cdots \qquad (I)$$

wherein,

$R^5$ represents an alkyl group having 1 to 10 carbon atoms or an aryl group having 6 to 10 carbon atoms;
$R^6$ represents an alkyl group having 1 to 10 carbon atoms, an aryl group having 6 to 10 carbon atoms or a hydrogen atom;
n represents a real number satisfying $1 < n < 2$; and m represents a real number satisfying $0 < m < 1$.

An oligomer B having an average composition formula represented by the following formula (I) contains the T unit and D unit described above.

In the formula (I), $R^5$ is preferably a methyl group, and $R^6$ is preferably a methyl group or a hydrogen atom. It is preferable that n is a real number satisfying $1 < n \leq 1.5$ and m is a real number satisfying $0.5 \leq m < 1$, and it is more preferable that n is a real number satisfying $1.1 \leq n \leq 1.4$ and m is a real number satisfying $0.55 \leq m \leq 0.75$. When n and m in the formula (I) are within these ranges, compatibility between the oligomer B and the silicone resin A is improved.

Among all structural units contained in the oligomer B, the structural unit represented by the formula (B1) and the structural unit represented by the formula (B1') in which one of two $R^4$s is an alkyl group having 1 to 10 carbon atoms or an aryl group having 6 to 10 carbon atoms and the other is an alkoxy group having 1 to 4 carbon atoms or a hydroxyl group is a "D1 unit".

Among all structural units contained in the oligomer B, the structural unit represented by the formula (B2) in which $R^4$ is an alkyl group having 1 to 10 carbon atoms or an aryl group having 6 to 10 carbon atoms is a "D2 unit".

In the case where the oligomer B is an oligomer containing a D unit (b), among all structural units contained in the oligomer B, the total content of the D1 unit and the D2 unit is preferably 5 to 80% by mole, more preferably 10 to 70% by mole, and further preferably 15 to 50% by mole.

(c) Oligomer containing T2 unit and D unit

The oligomer containing a T2 unit and a D unit (c) satisfies requirements of both the oligomer containing a T2 unit (a) and the oligomer containing a D unit (b).

Among all structural units contained in the oligomer B, the structural unit represented by the formula (B1) and the structural unit represented by the formula (B1') in which two $R^4$s are an alkoxy group having 1 to 4 carbon atoms or a hydroxyl group is a T1 unit.

Among all structural units contained in the oligomer B, the structural unit represented by the formula (B2) in which $R^4$ is an alkoxy group having 1 to 4 carbon atoms or a hydroxyl group is a T2 unit.

Among all structural units contained in the oligomer B, the structural unit represented by the formula (B3) is a T3 unit.

In the case where the oligomer B is an oligomer containing a T2 unit and a D unit (c), among all structural units contained in the oligomer B, the molar ratio of the total content of the T1 unit, T2 unit and T3 unit to the content of the D unit (T unit : D unit) is preferably 60 : 40 to 90 : 10.

The oligomer B corresponds to each of the above-described structural units constituting the silicone resin and can be synthesized using an organosilicon compound having a functional group capable of generating a siloxane bond as a starting material. Here, examples of the "functional group capable of forming a siloxane bond" include a halogen atom, a hydroxyl group, and an alkoxy group.

Examples of the organosilicon compound corresponding to the structural unit represented by the formula (B3) include organotrihalosilanes, organotrialkoxysilanes, and the like. Examples of the organosilicon compound corresponding to the structural unit represented by the formula (B2) include organodihalosilanes, organodialkoxysilanes, and the like.

The oligomer B can be synthesized by reacting an organosilicon compound as the starting material in a ratio corresponding to the abundance ratio of each structural unit by a hydrolysis condensation method, in the presence of an acid such as hydrochloric acid or a base such as sodium hydroxide. By appropriately selecting the organosilicon compound as the starting material, the abundance ratio of silicon atoms of the T unit and silicon atoms of the D unit contained in the oligomer B can be adjusted.

The content of the oligomer B contained in the condensed silicone resin is preferably 0.1% by mass to 20% by mass, more preferably 0.2% by mass to 15% by mass, and further preferably 0.5% by mass to 10% by mass, to the total content of all silicone resins contained in the condensed silicone resin.

Also, the content of the oligomer B contained in the condensed silicone resin is preferably 0.1% by mass to 20% by mass, more preferably 1% by mass to 15% by mass, and further preferably 5% by mass to 12% by mass, to the content of the silicone resin A contained in the condensed silicone resin.

<<Oligomer C>>

Examples of the other oligomer component include silicone resins containing the structural unit represented by the formula (A1), formula (A1'), formula (A2) or formula (A3) in which the ratio of the content of the structural unit represented by the formula (A3) to the total content of the structural units represented by the formula (A1), formula (A1'), formula (A2) and formula (A3) is 0 to 30% by mole, and the polystyrene equivalent weight average molecular weight is less than 1500.

In the following description, such silicone resin is referred to as "oligomer C".

The oligomer C is a silicone resin having a ratio of the content of the T3 silicon atoms to the total content of the T1 silicon atoms, the T2 silicon atoms and the T3 silicon atoms of 0 to 30% by mole, and a polystyrene equivalent weight average molecular weight of less than 1500. The ratio of the content of the T3 silicon atoms to the total content

of the T1 silicon atoms, the T2 silicon atoms and the T3 silicon atoms is preferably 0 to 25% by mole.

The oligomer C preferably has substantially no silicon atom bonded to a hydrogen atom (hydrosilyl group) and no silicon atom bonded to an alkenyl group. When the oligomer C has a silicon atom bonded to an alkenyl group or a hydrosilyl group, the cured product of the present embodiment tends to have low heat resistance.

The oligomer C is preferably an oligomer having an organopolysiloxane structure represented by the following formula (2).

[Chemical Formula 5]

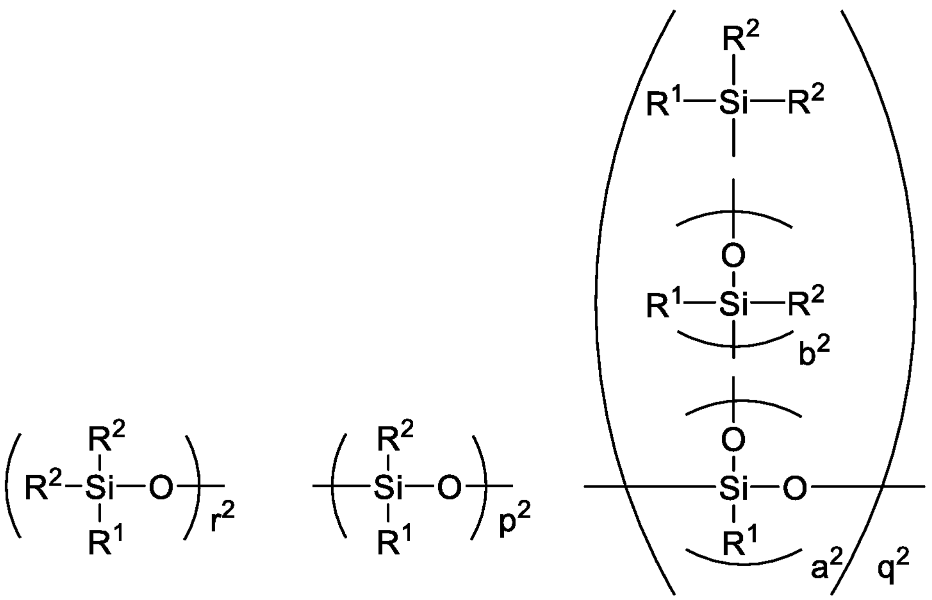

• • • (2)

Wherein,

$R^1$ and $R^2$ have the same meaning as described above, a plurality of $R^1$S and $R^2$s each may be the same or different, and

$p^2$, $q^2$, $r^2$, $a^2$ and $b^2$ represent any numbers equal to or greater than 0 such that $[a^2 \times q^2] / [(p^2 + b^2 \times q^2) + a^2 \times q^2 + (r^2 + q^2)] = 0$ to 0.3.

In the organopolysiloxane structure represented by the formula (2), it is preferable that $R^1$ is one or more groups selected from the group consisting of a methyl group, an ethyl group and a phenyl group, and $R^2$ is one or more groups selected from the group consisting of a methoxy group, an ethoxy group, an isopropoxy group and a hydroxyl group, and it is more preferable that $R^1$ is one or more groups selected from the group consisting of a methyl group and an ethyl group, and $R^2$ is one or more groups selected from the group consisting of a methoxy group, an ethoxy group and an isopropoxy group. In particular, from the viewpoint of heat resistance of the cured product of the present embodiment, $R^1$s are preferably methyl groups.

The abundance ratio of each structural unit of the oligomer C having the organopolysiloxane structure represented by the formula (2) can be represented by the abundance ratio of the T1 silicon atoms, the T2 silicon atoms, and the T3 silicon atoms. That is, T1 silicon atoms : T2 silicon atoms : T3 silicon atoms = $[r^2 + q^2] : [p^2 + b^2 \times q^2] : [a^2 \times q^2]$. The abundance ratio of each silicon atom in the oligomer C can be adjusted by appropriately adjusting the numerical values of $p^2$, $q^2$, $r^2$, $a^2$ and $b^2$. For example, when at least one of $a^2$ and $q^2$ is 0, a T3 silicon atom is not present in the oligomer C, and only linear or cyclic molecules are contained. On the other hand, when both $r^2$ and $q^2$ are 0, only T2 silicon atoms are present in the oligomer C and only cyclic molecules are contained.

In the organopolysiloxane structure represented by the formula (2), when the number of T2 silicon atoms is $x_2$, the number of T3 silicon atoms is $y_2$, and the number of T1 silicon atoms is $z_2$, the abundance ratio of the T3 silicon atoms in the organopolysiloxane structure represented by the formula (2) is represented by $[y_2/(x_2 + y_2 + z_2)]$.

$[a^2 \times q^2] / [(p^2 + b^2 \times q^2) + a^2 \times q^2 + (r^2 + q^2)]$ is equal to the abundance ratio of the T3 silicon atoms in the organopolysiloxane structure represented by the formula (2) : $[y_2/(x_2 + y_2 + z_2)]$. That is, $p^2$, $q^2$, $r^2$, $a^2$ and $b^2$ in the formula (2) are appropriately adjusted so that the abundance ratio of the T3 silicon atoms is within the range of 0 to 0.3.

The oligomer C, which may be contained in the condensed silicone resin as the raw material of the condensed silicone resin cured product contained in the cured product of the present embodiment, is a silicone resin having an organopolysiloxane structure represented by the formula (2), and is preferably an oligomer having a ratio of the content of the T3 silicon atoms to the total content of the T1 silicon atoms, T2 silicon atoms and T3 silicon atoms: $[y_2/(x_2 + y_2 + z_2)]$ of 0 to 0.3, and a polystyrene equivalent weight average molecular weight of less than 1500. When the abundance ratio of the T3 silicon atoms is within this range, the abundance ratio of the T2 silicon atoms: $[x_2/(x_2 + y_2 + z_2)]$ and the abundance ratio of the T1 silicon atoms: $[z_2/(x_2 + y_2 + z_2)]$ are not particularly limited. As the oligomer C, one having $[y_2/(x_2 + y_2 + z_2)]$ within the range of 0 to 0.25 is preferable, and within the range of 0.05 to 0.2 is more preferable.

The oligomer C has a relatively low abundance ratio of the T3 silicon atoms, and thus contains few branched chain structures and many linear molecules or cyclic molecules. The oligomer C may contain only cyclic molecules, but preferably contains many linear molecules. As the oligomer C, for example, one in which the abundance ratio of the T1 silicon atoms: $[z_2/(x_2 + y_2 + z_2)]$ is within the range of 0 to 0.80, more preferably within the range of 0.30 to 0.80, further preferably within the range of 0.35 to 0.75, and particularly preferably within the range of 0.35 to 0.55.

The content of the oligomer C contained in the condensed silicone resin is preferably 0.1% by mass to 20% by mass, more preferably 0.2% by mass to 15% by mass, and further preferably 0.5% by mass to 10% by mass, to the total content of all silicone resins contained in the condensed silicone resin.

Also, the content of the oligomer C contained in the condensed silicone resin is preferably 0.1% by mass to 20% by mass, more preferably 0.3% by mass to 10% by mass, and further preferably 0.5% by mass to 5% by mass, to the content of the silicone resin A contained in the condensed silicone resin.

The polystyrene equivalent weight average molecular weight of the oligomer C is less than 1500. When the polystyrene equivalent weight average molecular weight of the oligomer C is too large, crack resistance of the cured product of the present embodiment may be insufficient in some cases. The polystyrene equivalent weight average molecular weight of the oligomer C measured by GPC may be less than 1000.

The number of T1 silicon atoms, T2 silicon atoms and T3 silicon atoms in one molecule of the oligomer C is appropriately adjusted so that the resin having the organopolysiloxane structure represented by the formula (2) has a desired molecular weight. In one embodiment, the sum of the number of T1 silicon atoms, the number of T2 silicon atoms and the number of T3 silicon atoms in one molecule of the oligomer C is preferably 2 or more.

The oligomer C corresponds to each of the above-described structural units constituting the oligomer C and can be synthesized using an organosilicon compound having a functional group capable of generating a siloxane bond as a starting material. Here, the "functional group capable of forming a siloxane bond" has the same meaning as one described above. Examples of the organosilicon compound corresponding to the structural unit represented by the formula (A3) include organotrihalosilanes, organotrialkoxysilanes, and the like. The oligomer C can be synthesized by reacting such organosilicon compound as the starting material in a ratio corresponding to the abundance ratio of each structural unit by a hydrolysis condensation method.

Upon synthesis of the oligomer C, an organosilicon compound corresponding to the structural unit represented by the formula (A1) and an organosilicon compound corresponding to the structural unit represented by the formula (A1') are mixed as the starting material. When these organosilicon compounds are polymerized by hydrolysis condensation reaction, the organosilicon compounds are bound to the end of the polymerization reaction to stop the polymerization reaction.

The condensed silicone resin which is a raw material of the condensed silicone resin cured product contained in the cured product of the present embodiment preferably contains the silicone resin A and the oligomer component. As the oligomer component, the oligomer B or oligomer C is preferable. The condensed silicone resin which is a raw material of the condensed silicone resin cured product contained in the cured product of the present embodiment preferably contains the silicone resin A and the oligomer B, and more preferably the silicone resin A, the oligomer B, and the oligomer C.

Examples of the other oligomer component include silicone resins containing the structural unit represented by the formula (A1) and the structural unit represented by the formula (A2). The silicone resin may contain a D unit.

(Solvent)

The condensed silicone resin which is a raw material of the condensed silicone resin cured product contained in the cured product of the present embodiment has a high content of the T3 unit. Therefore, for the purpose of improving handling properties, a solvent may be added to the condensed silicone resin. A composition containing a condensed silicone resin and a solvent is referred to as "silicone resin composition".

The solvent is not particularly limited as long as it can dissolve the silicone resin. As the solvent, for example, two or more kinds of solvents having different boiling points (hereinafter referred to as solvent P and solvent Q) can be used.

As the solvent P, an organic solvent having a boiling point of lower than 100°C is preferable. Specifically, ketone

solvents such as acetone and methyl ethyl ketone; alcohol solvents such as methanol, ethanol, isopropyl alcohol and normal propyl alcohol; hydrocarbon solvents such as hexane, cyclohexane, heptane and benzene; ester acetate solvents such as ethyl acetate; and ether solvents such as diethyl ether and tetrahydrofuran are preferable.

Among them, alcohol solvents such as methanol, ethanol, isopropyl alcohol and normal propyl alcohol are more preferable as the solvent P.

As the solvent Q, an organic solvent having a boiling point of 100°C or more is preferable. Specifically, glycol ether solvents and glycol ester solvents are preferable.

Specific examples of the glycol ether solvents include ethylene glycol monomethyl ether, ethylene glycol monoethyl ether, ethylene glycol monoisopropyl ether, ethylene glycol monobutyl ether, ethylene glycol monohexyl ether, ethylene glycol monoethylhexyl ether, ethylene glycol monophenyl ether, ethylene glycol monobenzyl ether, diethylene glycol monomethyl ether, diethylene glycol monoethyl ether, diethylene glycol monoisopropyl ether, diethylene glycol monobutyl ether, diethylene glycol monohexyl ether, diethylene glycol monoethylhexyl ether, diethylene glycol monophenyl ether, diethylene glycol monobenzyl ether, propylene glycol monomethyl ether, propylene glycol monoethyl ether, propylene glycol monoisopropyl ether, propylene glycol monobutyl ether, propylene glycol monohexyl ether, propylene glycol monoethylhexyl ether, propylene glycol monophenyl ether, propylene glycol monobenzyl ether, dipropylene glycol monomethyl ether, dipropylene glycol monoethyl ether, dipropylene glycol monoisopropyl ether, dipropylene glycol monobutyl ether, dipropylene glycol monohexyl ether, dipropylene glycol monoethylhexyl ether, dipropylene glycol monophenyl ether, and dipropylene glycol monobenzyl ether.

Specific examples of the glycol ester solvents include ethylene glycol monoethyl ether acetate, ethylene glycol monoisopropyl ether acetate, ethylene glycol monobutyl ether acetate, ethylene glycol monohexyl ether acetate, ethylene glycol monoethylhexyl ether acetate, ethylene glycol monophenyl ether acetate, and ethylene glycol monobenzyl ether acetate.

Among them, ethylene glycol monobutyl ether, diethylene glycol monobutyl ether, dipropylene glycol monomethyl ether and ethylene glycol monobutyl ether acetate are more preferable as the solvent Q.

(Silicone Resin Composition)

The condensed silicone resin which is a raw material of the condensed silicone resin cured product contained in the cured product of the present embodiment and a solvent are mixed to obtain a silicone resin composition. The silicone resin composition may contain a curing catalyst, a filler, and other components described later.

The viscosity of the silicone resin composition is usually 100 to 500000 mPa · s, preferably 300 to 20000 mPa · s, more preferably 400 to 15000 mPa · s, and further preferably 500 to 10000 mPa · s at 25°C. When the viscosity of the silicone resin composition is within the above range, in a case where the silicone resin composition further contains a wavelength conversion material, mixing performance of the condensed silicone resin with the wavelength conversion material is good and sedimentation of the wavelength conversion material is suppressed.

<<Mixing Ratio>>

The condensed silicone resin which is a raw material of the condensed silicone resin cured product contained in the cured product of the present embodiment contains the silicone resin A as an essential component, and may contain oligomer components (oligomer B, oligomer C, etc.), a solvent, a curing catalyst, a filler or other components, as necessary.

When preparing the condensed silicone resin, $d_{Max}$ can be controlled by adjusting the combination ratio of the silicone resin A and the oligomer. Specifically, as the combination ratio of the oligomer component is increased, $d_{Max}$ tends to increase. This is considered to be due to the fact that the reactivity of the condensed silicone resin is improved by increasing the combination ratio of the oligomer component and the difference between the portion where the polymerization reaction speed is fast and the portion where the polymerization reaction speed is slow increases. As a result, inhomogeneity of the obtained cured product is increased and $d_{Max}$ is increased.

As the ratio (mass ratio) of the silicone resin A and the oligomer component, the oligomer component is preferably 0.1 to 80 parts by mass, more preferably 1 to 50 parts by mass, further preferably 1 to 30 parts by mass, particularly preferably 1 to 20 parts by mass, and more particularly preferably 5 to 15 parts by mass, to 100 parts by mass of the silicone resin A.

When the combination ratio of the silicone resin A and the oligomer component is within the above range, the speed of the polymerization reaction is controlled and $d_{Max}$ can be controlled to 170 Å or less.

When the silicone resin A, the oligomer B and the oligomer C are used for preparing the condensed silicone resin, the mixing ratio of the silicone resin is such that preferably silicone resin A : oligomer B : oligomer C = 100 : 0.2 to 15 : 0.2 to 15 (mass ratio), and more preferably silicone resin A : oligomer B : oligomer C = 100 : 1 to 10 : 1 to 10 (mass ratio).

<<Method for Producing Silicone Resin Composition>>

The mixing method of the silicone resin A, the oligomer B and the oligomer C is not particularly limited, and any of known methods performed when mixing two or more types of polymers may be used. For example, each of the silicone resin A, the oligomer B, the oligomer C, and optionally other components may be dissolved in an organic solvent, and then the obtained solution may be mixed.

The silicone resin can be more homogeneously mixed and stability of the prepared silicone resin composition can be improved. Therefore, it is preferable that the silicone resin is dissolved in a highly volatile and highly soluble organic solvent, and then the organic solvent is replaced with another solvent.

Specifically, first, the silicone resin A is added to a highly volatile and highly soluble organic solvent (for example, the solvent P), then the mixture is heated to a temperature near the boiling point of the solvent P and stirred to dissolve the silicone resin A in the solvent P.

Next, the oligomer B, the oligomer C and optionally other components are added to the obtained solution, and then the oligomer B, the oligomer C and optionally other components are dissolved in the solvent P by the same method as described above.

Next, a solvent having a lower volatility than the solvent P (for example, the solvent Q) is added to the obtained solution, and then the mixture was heated and distilled until the concentration of the solvent P becomes 1% or less, whereby the solvent P can be replaced with the solvent Q. In order to efficiently perform solvent replacement, heating distillation may be performed under reduced pressure.

Residual solvents, water and the like that can be contained in each of the silicone resin A, the oligomer B, the oligomer C and other components can be removed by performing solvent replacement. Therefore, by solvent replacement, stability of the silicone resin composition can be improved.

(ii) Control by curing conditions of silicone resin

A method of controlling the parameter $d_{Max}$ by controlling the curing conditions of the silicone resin will be described.

Inhomogeneity of the obtained cured product changes according to the rate of a curing reaction of the condensed silicone resin. By increasing the temperature rise rate when raising the temperature from a low temperature state (for example, room temperature) to 120°C, the distribution of the T3 silicon atoms in the cured product tends to be homogeneous. Therefore, the parameter $d_{Max}$ can be reduced by increasing the temperature rise rate to 120°C.

In order to reduce the parameter $d_{Max}$, it is preferable to set the rate of temperature rise from 80°C to 120°C to 4°C/min or more. By setting the rate of temperature rise from 80°C to 120°C to 4°C/min or more, it is possible to proceed a curing reaction in a state where the condensed silicone resin has high molecular mobility even at a temperature of 120°C or more. Therefore, the reaction in the silicone resin can proceed relatively homogeneously.

Further, it is preferable to perform a curing reaction at a temperature of 150°C or more for 5 hours or more.

In addition, the parameter $d_{Max}$ can be reduced by increasing the temperature of the curing reaction. For example, the parameter $d_{Max}$ can be reduced by performing a curing reaction at 200°C.

In order to control the rate of the curing reaction, a curing accelerator such as a phosphoric acid-based catalyst or a metallic catalyst may be added to the silicone resin.

(Curing Catalyst)

As the curing catalyst, for example, in a case where the silicone resin A and the oligomer component have an alkoxy group or a hydroxyl group bonded to a silicon atom, an inorganic acid such as hydrochloric acid, sulfuric acid, nitric acid, phosphoric acid or phosphoric acid ester; or an organic acid such as formic acid, acetic acid, oxalic acid, citric acid, propionic acid, butyric acid, lactic acid or succinic acid can be used, in order to accelerate hydrolysis condensation reaction.

As the curing catalyst, not only an acidic compound but also an alkaline compound can be used. Specifically, ammonium hydroxide, tetramethylammonium hydroxide, tetraethylammonium hydroxide or the like can be used as the curing catalyst.

As the curing catalyst, an organometallic compound catalyst can also be used. Specifically, as the curing catalyst, an organometallic compound catalyst containing aluminum, zirconium, tin, titanium or zinc can be used.

Examples of the organometallic compound catalyst containing aluminum include aluminum triacetylacetate and aluminum triisopropoxide.

Examples of the organometallic compound catalyst containing zirconium include zirconium tetraacetylacetonate, zirconium tributoxyacetylacetonate, zirconium dibutoxydiacetylacetonate, zirconium tetranormalbutoxide, zirconium tetraisopropoxide, zirconium tetranormalbutoxide, zirconium acylate, and zirconium tributoxystearate.

Examples of the organometallic compound catalyst containing tin include tetrabutyltin, monobutyltin trichloride, dibutyltin dichloride, dibutyltin oxide, tetraoctyltin, dioctyltin dichloride, dioctyltin oxide, tetramethyltin, dibutyltin laurate, dioctyltin dilaurate, bis(2-ethylhexanoate)tin, bis(neodecanoate)tin, di-n-butylbis(ethylhexylmalate)tin, di-normalbutylbis(2,4-pentanedionate)tin, di-normalbutyl butoxy chlorotin, di-normalbutyl diacetoxytin, di-normalbutyltin dilaurate, and dimethyltin dineodecanoate.
Examples of the organometallic compound catalyst containing titanium include titanium tetraisopropoxide, titanium tetranormalbutoxide, butyl titanate dimer, tetraoctyl titanate, titanium acetylacetonate, titanium octylene glycolate, and titanium ethyl acetoacetate.
Examples of the organometallic compound catalyst containing zinc include zinc triacetylacetonate.
Among them, phosphoric acid ester or phosphoric acid is preferable, and phosphoric acid is more preferable, from the viewpoint of transparency of the obtained cured product.
In order to add the curing catalyst to the silicone resin at a predetermined concentration, it is preferable to dilute the cured product catalyst into water, an organic solvent, a silicone-based monomer, an alkoxysilane oligomer or the like and then add it to the silicone resin.
The content of the curing catalyst can be appropriately adjusted in consideration of the temperature and time of the curing reaction of the silicone resin, the type of catalyst, and the like. The content of the curing catalyst is preferably 0.01 parts by mass or more and 10 parts by mass or less, more preferably 0.01 parts by mass or more and 5 parts by mass or less, and further preferably 0.1 parts by mass or more and 1 part by mass or less, to 100 parts by mass of the condensed silicone resin.
The curing catalyst may be added to the silicone resin beforehand or may be added to the silicone resin immediately before performing the curing reaction of the silicone resin.

(Filler)

In the cured product of the present embodiment, the filler may be dispersed in the condensed silicone resin cured product. As the filler, a wavelength conversion material is preferable.
Examples of the wavelength conversion material include a phosphor and a quantum dot. Examples of the phosphor include red phosphors emitting fluorescence in the wavelength range of 570 nm to 700 nm, green phosphors emitting fluorescence in the range of 490 nm to 570 nm, and blue phosphors emitting fluorescence in the range of 420 nm to 480 nm.

<<Red Phosphor>>

Examples of the red phosphor include europium-activated alkaline earth silicon nitride phosphors expressed by $(Mg,Ca,Sr,Ba)_2Si_5N_8$:Eu, which are composed of broken particles having red broken surfaces, and europium-activated rare-earth oxychalcogenide phosphors expressed by $(Y,La,Gd,Lu)_2O_2S$:Eu, which are composed of grown particles having a nearly spherical shape as the regular crystal growth shape.
Examples of other red phosphor include phosphors containing an oxynitride and/or oxysulfide containing at least one element selected from the group consisting of Ti, Zr, Hf, Nb, Ta, W and Mo and containing an oxynitride having an alpha-sialon structure in which part or all of Al elements are substituted with Ga elements.
Other examples of the red phosphor include Eu-activated oxysulfide phosphors such as $(La, Y)_2O_2S$:Eu; Eu-activated oxide phosphors such as $Y(V,P)O_4$:Eu and $Y_2O_3$:Eu; Eu,Mn-activated silicate phosphors such as $(Ba,Sr,Ca,Mg)_2SiO_4$:Eu,Mn and $(Ba,Mg)_2SiO_4$:Eu,Mn; Eu-activated sulfide phosphors such as (Ca,Sr)S:Eu; Eu-activated aluminate phosphors such as $YAlO_3$:Eu; Eu-activated silicate phosphors such as $LiY_9(SiO_4)_6O_2$:Eu, $Ca_2Y_8(SiO_4)_6O_2$:Eu, $(Sr,Ba,Ca)_3SiO_5$:Eu and $Sr_2BaSiO_5$:Eu; Ce-activated aluminate phosphors such as $(Y,Gd)_3Al_5O_{12}$:Ce and $(Tb,Gd)_3Al_5O_{12}$:Ce; Eu-activated nitride phosphors such as $(Ca,Sr,Ba)_2Si_5N_8$:Eu, $(Mg,Ca,Sr,Ba)SiN_2$:Eu and $(Mg,Ca,Sr,Ba)AlSiN_3$:Eu; Ce-activated nitride phosphors such as $(Mg,Ca,Sr,Ba)AlSiN_3$:Ce; Eu,Mn-activated halophosphate phosphors such as $(Sr,Ca,Ba,Mg)_{10}(PO_4)_6Cl_2$:Eu,Mn; Eu, Mn-activated silicate salt phosphors such as $(Ba_3Mg)Si_2O_8$:Eu,Mn and $(Ba,Sr,Ca,Mg)_3(Zn,Mg)Si_2O_8$:Eu,Mn; Mn-activated germanate phosphors such as $3.5MgO \cdot 0.5MgF_2 \cdot GeO_2$:Mn; Eu-activated oxynitride phosphors such as Eu-activated $\alpha$ sialon; Eu,Bi-activated oxide phosphors such as $(Gd,Y,Lu,La)_2O_3$:Eu,Bi; Eu,Bi-activated oxysulfide phosphors such as $(Gd,Y,Lu,La)_2O_2S$:Eu,Bi; Eu,Bi-activated vanadate phosphors such as $(Gd,Y,Lu,La)VO_4$:Eu,Bi; Eu,Ce-activated sulfide phosphors such as $SrY_2S_4$:Eu,Ce; Ce-activated sulfide phosphors such as $CaLa_2S_4$:Ce; Eu,Mn-activated phosphate phosphors such as $(Ba,Sr,Ca)MgP_2O_7$:Eu,Mn and $(Sr,Ca,Ba,Mg,Zn)_2P_2O_7$:Eu,Mn; Eu,Mo-activated tungstate phosphors such as $(Y,Lu)_2WO_6$:Eu,Mo; Eu, Ce-activated nitride phosphors such as $(Ba,Sr,Ca)_xSi_yN_z$:Eu,Ce (wherein x, y, and z are integers of 1 or more); Eu,Mn-activated halophosphate phosphors such as $(Ca,Sr,Ba,Mg)_{10}(PO_4)_6(F,Cl,Br,OH)$:Eu,Mn; and Ce-activated silicate phosphors such as $((Y, Lu, Gd, Tb)_{1-x}Sc_xCe_y)_2(Ca,Mg)_{1-r}(Mg, Zn)_{2+r}Si_{z-q}Ge_qO_{12+\delta}$.
Other examples of the red phosphor include red organic phosphors composed of a rare earth element ion

complex containing an anion such as β-diketonate, β-diketone, aromatic carboxylic acid or Bronsted acid, as a ligand, perylene pigments (for example, dibenzo{[f,f']-4,4',7,7'-tetraphenyl}diindeno[1,2,3-cd:1',2',3'-lm]perylene), anthraquinone pigments, lake pigments, azo pigments, quinacridone pigments, anthracene pigments, isoindoline pigments, isoindolinone pigments, phthalocyanine pigments, triphenylmethane basic dyes, indanthrone pigments, indophenol pigments, cyanine pigments, and dioxazine pigments.

Among the red phosphors, a red phosphor having a peak wavelength of fluorescence emission of 580 nm or more and preferably 590 nm or more, and a peak wavelength of fluorescence emission of 620 nm or less and preferably 610 nm or less is suitably used as an orange phosphor. Examples of such orange phosphor include $(Sr,Ba)_3SiO_5$:Eu, $(Sr,Mg)_3(PO_4)_2$:$Sn^{2+}$, and $SrCaAlSiN_3$:Eu.

<<Yellow Phosphor>>

Examples of the yellow phosphor include oxide-based, nitride-based, oxynitride-based, sulfide-based and oxysulfide-based phosphors. Specific examples include garnet-based phosphors having a garnet structure represented by $RE_3M_5O_{12}$:Ce (wherein RE represents at least one element selected from the group consisting of Y, Tb, Gd, Lu and Sm, and M represents at least one element selected from the group consisting of Al, Ga and Sc), $M^2{}_3M^3{}_2M^4{}_3O_{12}$: Ce (wherein $M^2$ represents a divalent metal element, $M^3$ represents a trivalent metal element, and $M^4$ represents a tetravalent metal element) or the like; orthosilicate-based phosphors represented by $AE_2M^5O_4$:Eu (wherein AE represents at least one element selected from the group consisting of Ba, Sr, Ca, Mg and Zn, and $M^5$ represents at least one element selected from the group consisting of Si and Ge) or the like; oxynitride-based phosphors where a part of oxygen atoms as a constituent element of these phosphors is substituted with a nitrogen atom; and phosphors activated by Ce such as nitride-based phosphors having a $CaAlSiN_3$ structure such as $AEAlSiN_3$:Ce (wherein AE represents at least one element selected from the group consisting of Ba, Sr, Ca, Mg and Zn).

Examples of other yellow phosphors include phosphors activated by Eu such as sulfide-based phosphors such as $CaGa_2S_4$:Eu$(Ca,Sr)Ga_2S_4$:Eu and (Ca,Sr) $(Ga,Al)_2S_4$:Eu; and oxynitride-based phosphors having a SiAlON structure such as $Ca_x(Si,Al)_{12}(O,N)_{16}$:Eu.

<<Green Phosphor>>

Examples of the green phosphor include europium-activated alkaline earth silicon oxynitride-based phosphors represented by $(Mg,Ca,Sr,Ba)Si_2O_2N_2$:Eu, which are composed of broken particles having broken surfaces, and europium-activated alkaline earth silicate-based phosphors represented by $(Ba,Ca,Sr,Mg)_2SiO_4$:Eu, which are composed of broken particles having broken surfaces.

Other examples of the green phosphor include Eu-activated aluminate phosphors such as $Sr_4Al_{14}O_{25}$:Eu and $(Ba,Sr,Ca)Al_2O_4$:Eu; Eu-activated silicate salt phosphors such as $(Sr,Ba)Al_2Si_2O_8$:Eu, $(Ba,Mg)_2SiO_4$:Eu, $(Ba,Sr,Ca,Mg)_2SiO_4$:Eu and $(Ba,Sr,Ca)_2(Mg,Zn)Si_2O_7$:Eu; Ce,Tb-activated silicate phosphors such as $Y_2SiO_5$:Ce,Tb; Eu-activated borate phosphate phosphors such as $Sr_2P_2O_7$-$Sr_2B_2O_5$:Eu; Eu-activated halosilicate phosphors such as $Sr_2Si_3O_8$-$2SrCl_2$:Eu; Mn-activated silicate phosphors such as $Zn_2SiO_4$:Mn; Tb-activated aluminate phosphors such as $CeMgAl_{11}O_{19}$:Tb and $Y_3Al_5O_{12}$:Tb; Tb-activated silicate phosphors such as $Ca_2Y_8(SiO_4)_6O_2$:Tb and $La_3Ga_5SiO_{14}$:Tb; Eu,Tb,Sm-activated thiogallate phosphors such as $(Sr,Ba,Ca)Ga_2S_4$:Eu,Tb,Sm; Ce-activated aluminate phosphors such as $Y_3(Al,Ga)_5O_{12}$:Ce and $(Y,Ga,Tb,La,Sm,Pr,Lu)_3(Al,Ga)_5O_{12}$:Ce; Ce-activated silicate phosphors such as $Ca_3Sc_2Si_3O_{12}$: Ce and $Ca_3(Sc,Mg,Na,Li)_2Si_3O_{12}$:Ce; Ce-activated oxide phosphors such as $CaSc_2O_4$:Ce; Eu-activated oxynitride phosphors such as $SrSi_2O_2N_2$:Eu, $(Sr,Ba,Ca)Si_2O_2N_2$:Eu, Eu-activated β-sialon and Eu-activated α-sialon; Eu,Mn-activated aluminate phosphors such as $BaMgAl_{10}O_{17}$:Eu,Mn; Eu-activated aluminate phosphors such as $SrAl_2O_4$:Eu; Tb-activated oxysulfide phosphors such as $(La,Gd,Y)_2O_2S$:Tb; Ce,Tb-activated phosphate phosphors such as $LaPO_4$:Ce,Tb; sulfide phosphors such as ZnS:Cu,Al and ZnS:Cu,Au,Al; Ce,Tb-activated borate phosphors such as (Y, Ga, Lu, Sc, La)$BO_3$:Ce, Tb, $Na_2Gd_2B_2O_7$ : Ce, Tb and $(Ba,Sr)_2(Ca,Mg,Zn)B_2O_6$:K,Ce,Tb; Eu,Mn-activated halosilicate phosphors such as $Ca_8Mg(SiO_4)_4Cl_2$:Eu,Mn; Eu-activated thioaluminate phosphors or thiogallate phosphors such as (Sr,Ca,Ba) $(Al,Ga,In)_2S_4$:Eu, and Eu,Mn-activated halosilicate phosphors such as $(Ca,Sr)_8(Mg,Zn)(SiO_4)_4Cl_2$:Eu,Mn.

Other examples of the green phosphor include pyridine-phthalimide condensation derivatives, benzoxazinone-based, quinazolinone-based, coumarin-based, quinophthalone-based and naphthalimide-based fluorescent dyes; and organic phosphors such as terbium complexes having hexyl salicylate as a ligand.

<<Blue Phosphor>>

Examples of the blue phosphor include europium-activated barium magnesium aluminate-based phosphors represented by $BaMgAl_{10}O_{17}$:Eu, which are composed of grown particles having a nearly hexagonal shape as the regular crystal growth shape, europium-activated calcium halophosphate-based phosphors represented by

$(Ca,Sr,Ba)_5(PO_4)_3Cl$:Eu, which are composed of grown particles having a nearly spherical shapes as the regular crystal growth shape, europium-activated alkaline earth chloroborate-based phosphors represented by $(Ca,Sr,Ba)_2B_5O_9Cl$:Eu, which are composed of grown particles having a nearly cubic shapes as the regular crystal growth shape, and europium-activated alkaline earth aluminate-based phosphors represented by $(Sr,Ca,Ba)Al_2O_4$:Eu or $(Sr,Ca,Ba)_4Al_14O_{25}$:Eu, which are composed of broken particles having broken surfaces.

Other examples of the blue phosphor include Sn-activated phosphate phosphors such as $Sr_2P_2O_7$:Sn; Eu-activated aluminate phosphors such as $Sr_4Al_{14}O_{25}$:Eu, $BaMgAl_{10}O_{17}$:Eu and $BaAl_8O_{13}$:Eu; Ce-activated thiogallate phosphors such as $SrGa_2S_4$:Ce and $CaGa_2S_4$:Ce; Eu-activated aluminate phosphors such as $(Ba,Sr,Ca)MgAl_{10}O_{17}$:Eu and $BaMgAl_{10}O_{17}$:Eu,Tb,Sm; Eu,Mn-activated aluminate phosphors such as $(Ba,Sr,Ca)MgAl_{10}O_{17}$:Eu,Mn; Eu-activated halophosphate phosphors such as $(Sr,Ca,Ba,Mg)_{10}(PO_4)_6Cl_2$:Eu and $(Ba,Sr,Ca)_5(PO_4)_3(Cl,F,Br,OH)$:Eu,Mn,Sb; Eu-activated silicate phosphors such as $BaAl_2Si_2O_8$:Eu and $(Sr,Ba)_3MgSi_2O_8$:Eu; Eu-activated phosphate phosphors such as $Sr_2P_2O_7$:Eu; sulfide phosphors such as ZnS:Ag and ZnS:Ag,Al; Ce-activated silicate phosphors such as $Y_2SiO_5$:Ce; tungstate phosphors such as $CaWO_4$; Eu,Mn-activated borate phosphate phosphors such as (Ba,Sr,Ca)BPOs:Eu,Mn, $(Sr,Ca)_{10}(PO_4)_6 \cdot nB_2O_3$:Eu and $2SrO \cdot 0.84P_2O_5 \cdot 0.16B_2O_3$:Eu; and Eu-activated halosilicate phosphors such as $Sr_2Si_3O \cdot 2SrCl_2$:Eu.

Other examples of the blue phosphor include fluorescent dyes such as naphthalimide-based compounds, benzoxazole-based compounds, styryl-based compounds, coumarin-based compounds, pyralizone-based compounds and triazole-based compounds; organic phosphors such as thulium complexes; and the like.

Only one type of these phosphors may be used alone, or two or more types thereof may be used in combination.

<<Quantum Dot>>

Examples of the quantum dots include InAs-based quantum dots, and CdE (E = S, Se, Te)-based quantum dots ($CdS_xSe_{1-x}$/ZnS, and the like) .

The content of the wavelength conversion material is usually 20% by mass or more and 95% by mass or less, preferably 40% by mass or more and 95% by mass or less, more preferably 50% by mass or more and 95% by mass or less, and further preferably 60% by mass or more and 95% by mass or less, to the total content of the condensed silicone resin cured product and the wavelength conversion material.

In addition, the cured product of the present embodiment may contain a silicone filler. Examples of the silicone filler include a silicone resin filler and a silicone rubber filler.

(Other Components)

The cured product of the present embodiment may contain additives such as inorganic particles and a silane coupling agent, in addition to the condensed silicone resin cured product and the filler.

(Inorganic Particles)

The inorganic particles can effectively excite the wavelength conversion material by scattering light in the cured product of the present embodiment. In addition, it is possible to suppress sedimentation of the wavelength conversion material in the composition containing the silicone resin at the stage of producing the cured product of the present embodiment.

Examples of the inorganic particles include oxides of silicon, titanium, zirconia, aluminum, iron, zinc and the like, carbon black, barium titanate, calcium silicate, and calcium carbonate, and an oxide of silicon, titanium, zirconia, aluminum and the like is preferable.

Examples of the shape of the inorganic particles include a substantially spherical shape, a plate shape, a column shape, a needle shape, a whisker shape and a fibrous shape, and a substantially spherical shape is preferable since a more homogeneous composition is obtained.

The cured product of the present embodiment may contain only one type of inorganic particles or two or more types of inorganic particles, but it is preferable that the inorganic particles are two or more types of inorganic particles having different particle sizes. Specifically, it is more preferable that the cured product of the present embodiment includes inorganic particles with an average particle diameter of primary particles of 100 nm or more and 500 nm or less and inorganic particles with an average particle diameter of primary particles of less than 100 nm. By containing two or more types of inorganic particles having different average particle sizes of primary particles, excitation efficiency of the wavelength conversion material due to scattering of light is improved and sedimentation of the wavelength conversion material in the composition containing the silicone resin is suppressed.

The average particle size of primary particles of the inorganic particles can be determined, for example, by imaging method in which particles are directly observed with an electron microscope or the like.

Specifically, first, a liquid in which inorganic particles to be measured are dispersed in an any solvent is prepared, and the obtained dispersion is dropped on a slide glass or the like and dried. It may be prepared by directly spraying the inorganic particles on an adhesive surface of an adhesive tape to adhere the inorganic particles to the tape.

Next, the particles are directly observed with a scanning electron microscope (SEM) or a transmission electron microscope (TEM), and the dimension of the inorganic particles is determined from the obtained shape to determine the average particle size of primary particles of the inorganic particles.

The content of the inorganic particles is preferably 0.01 parts by mass or more and 100 parts by mass or less and more preferably 0.1 parts by mass or more and 50 parts by mass or less, to 100 parts by mass of the condensed silicone resin cured product.

(Silane Coupling Agent)

Examples of the silane coupling agent include silane coupling agents having at least one group selected from the group consisting of a vinyl group, an epoxy group, a styryl group, a methacryl group, an acryl group, an amino group, an ureido group, a mercapto group, a sulfide group, and an isocyanate group. Among them, a coupling agent having an epoxy group or a mercapto group is preferable.

Specific examples of the silane coupling agent include 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, 3-mercaptopropylmethyldimethoxysilane, and 3-mercaptopropyltrimethoxysilane.

When a silane coupling agent is contained in the composition containing the silicone resin, the silicon atom contained in the silane coupling agent is also detected as a signal of $^{29}$Si-NMR, but in the present specification, the signal of the silane coupling agent is also included when calculating the signal area of the composition containing the silicone resin.

The content of the silane coupling agent is preferably 0.0001 parts by mass or more and 1.0 part by mass or less, and more preferably 0.001 parts by mass or more and 0.1 parts by mass or less, to 100 parts by mass of the total content of the silicone resin.

(Other Additives)

The cured product of the present embodiment may contain additives other than the above-described materials. Examples of the additives other than the above-described materials include a dispersant, a leveling agent, and a defoaming agent.

(Cured Product)

The condensed silicone resin cured product contained in the cured product of the present embodiment preferably contains a structural unit represented by the formula (A3). Also, the condensed silicone resin cured product more preferably further contains one or more structural units selected from the group consisting of the structural unit represented by the formula (A1), the structural unit represented by the formula (A1'), and the structural unit represented by the formula (A2).

The condensed silicone resin cured product contained in the cured product of the present embodiment may further contain a structural unit represented by the formula (C1), formula (C1'), formula (C2), formula (C3) or formula (C4).

In the condensed silicone resin cured product contained in the cured product of the present embodiment, the content of the T3 unit is preferably 50% by mole or more, to the total content of all structural units of the condensed silicone resin cured product. In other words, the content of the T3 silicon atoms is preferably 50% by mole or more, to the total content of all silicon atoms of the condensed silicone resin cured product. Further, the content of the T3 silicon atoms is more preferably 60% by mole or more, further preferably 70% by mole or more, and still more preferably 75% by mole or more, to the total content of all silicon atoms of the condensed silicone resin cured product.

The parameter $d_{Max}$ representing the scale of inhomogeneity of the crosslinking points (T3 silicon) of the condensed silicone resin cured product contained in the cured product of the present embodiment is preferably 40 to 170 Å. A condensed silicone resin cured product satisfying the parameter $d_{Max}$ within this range has hardness (70 or more in Shore D hardness), high crack resistance, and high heat resistance suitable for device application.

The condensed silicone resin cured product having the parameter $d_{Max}$ within the above range can disperse stress to the entire cured product even when stress is applied. In the condensed silicone resin cured product having a parameter $d_{Max}$ of 40 Å or more, since the distance between portions having a high density of crosslinking points is large, it becomes a cured product having sufficient flexibility and cracks are less likely to occur. In addition, in the condensed silicone resin cured product having a parameter $d_{Max}$ of 170 Å or less, since the distance between portions having a high density of crosslinking points is not too large, it becomes a cured product having hardness suitable for

application to a device.

That is, the condensed silicone resin cured product having a parameter $d_{Max}$ of 40 Å or more and 170 Å or less can achieve both high hardness and high crack resistance.

The parameter $d_{Max}$ is preferably 50 Å or more, more preferably 60 Å or more, further preferably 70 Å or more, particularly preferably 80 Å or more, more particularly preferably 90 Å or more, and still more particularly preferably 100 Å or more.

The parameter $d_{Max}$ is preferably 160 Å or less.

In addition, even when heat of high temperature (for example, 250°C) is continuously applied, the condensed silicone resin cured product having a parameter $d_{Max}$ of 40 Å or more and 170 Å or less can disperse stress due to heat, by an inhomogenous structure contained in the cured product.

The cured product of the present embodiment satisfying the above requirements has high hardness, high crack resistance, and high heat resistance.

<Wavelength Conversion Sheet>

Fig. 2 is a schematic diagram showing the wavelength conversion sheet of the present embodiment. The wavelength conversion sheet 30 uses a cured product containing a condensed silicone resin cured product 40 and a filler 50 which is a wavelength conversion material dispersed in the condensed silicone resin cured product 40 as a forming material. Such wavelength conversion sheet 30 is formed into a thin plate shape using the above-described cured product of the present embodiment as a forming material.

The wavelength conversion sheet 30 may include a substrate on one surface. The substrate may be appropriately selected according to the application of the wavelength conversion sheet, and examples thereof include metal substrates such as aluminum; and transparent substrates such as quartz and sapphire.

The wavelength conversion sheet of the present embodiment can be used for application of wavelength conversion for LEDs, solar cells, semiconductor lasers, photodiodes, CCDs, CMOS, and the like. In particular, since the wavelength conversion sheet of the present embodiment has excellent heat resistance, it can be suitably used for a light emitting portion of semiconductor laser which is expected to be used at high temperature.

The wavelength conversion sheet of the present embodiment may contain the above-described inorganic particles. By containing the inorganic particles, it is possible to effectively excite the wavelength conversion material by scattering light in the wavelength conversion sheet. Further, it is possible to suppress sedimentation of the wavelength conversion material in the composition containing the silicone resin at the stage of producing the wavelength conversion sheet.

(Film Thickness)

The thickness (film thickness) of the wavelength conversion sheet is preferably 10 μm or more because the wavelength conversion sheet can be stably produced. Also, the thickness of the wavelength conversion sheet is preferably 1 mm or less, more preferably 500 μm or less, and further preferably 200 μm or less, from the viewpoint of enhancing optical characteristics and heat resistance of the wavelength conversion sheet. When the thickness of the wavelength conversion sheet is 1 mm or less, light absorption and light scattering due to the silicone resin can be reduced.

The film thickness of the wavelength conversion sheet can be obtained, for example, by measuring film thickness at a plurality of positions on the wavelength conversion sheet using a micrometer and calculating the average value thereof. For example, in a case where the shape of the wavelength conversion sheet is a quadrangle, the plurality of positions includes a total of five positions of one central position of the wavelength conversion sheet and four corner positions of the wavelength conversion sheet.

The wavelength conversion sheet 30 may be formed on a support substrate. As the support substrate, a substrate using known metal, film, glass, ceramic, paper or the like as a forming material can be used.

Specific examples of materials for forming the support substrate include transparent inorganic oxide glass such as quartz glass, borosilicate glass and sapphire; metal plates or foils such as aluminum (including aluminum alloys), zinc, copper and iron; plastic films such as cellulose acetate, polyethylene terephthalate (PET), polyethylene, polyester, polyamide, polyimide, polyphenylene sulfide, polystyrene, polypropylene, polycarbonate, polyvinyl acetal and aramid; papers laminated with the above plastic; papers coated with the above plastic; papers laminated or deposited with the above metal; and plastic films laminated or deposited with the above metal. Among them, an inorganic oxide glass or a metal plate is preferable.

The thickness of the support substrate is preferably 30 μm or more, and more preferably 50 μm or more. When the thickness of the support substrate is 30 μm or more, it has sufficient strength to protect the shape of the wavelength conversion sheet. Also, the thickness of the support substrate is preferably 5000 μm or less, and more preferably 3000 μm or less, from the viewpoint of economy.

(Method for Producing Wavelength Conversion Sheet)

A method for producing the wavelength conversion sheet of the present embodiment will be described.

First, a wavelength conversion material-containing silicone resin composition in which a wavelength conversion material is dispersed in the above-described silicone resin composition (condensed silicone resin + solvent) is prepared. At that time, as described above, by controlling the combination ratio of the silicone resin contained in the wavelength conversion material-containing silicone resin composition, it is possible to control the parameter $d_{Max}$ of the cured product constituting the wavelength conversion sheet to be produced.

Additives such as inorganic particles and adhesion aid may be contained in the wavelength conversion material-containing silicone resin composition, for diffusing the wavelength conversion material and improving coating properties of the wavelength conversion material-containing silicone resin composition.

These components are blended so as to have a predetermined composition and then homogeneously mixed and dispersed using a known stirring and kneading machine, whereby a wavelength conversion material-containing silicone resin composition can be obtained. Examples of the known stirring and kneading machines include a homogenizer, a rotation/revolution stirrer, a three-roller, a ball mill, a planetary ball mill, and a bead mill. After mixing and dispersing or in a mixing and dispersing process, the wavelength conversion material-containing silicone resin composition may be defoamed as necessary under vacuum or reduced pressure conditions.

Next, the obtained wavelength conversion material-containing silicone resin composition is applied on a support substrate. Application of the wavelength conversion material-containing silicone resin composition can be performed using a known coating apparatus. Examples of the known coating apparatus include a reverse roll coater, a blade coater, a slit die coater, a direct gravure coater, an offset gravure coater, a reverse roll coater, a blade coater, a kiss coater, a natural roll coater, an air knife coater, a roll blade coater, a variable roll blade coater, a two stream coater, a rod coater, a wire bar coater, an applicator, a dip coater, a curtain coater, a spin coater, and a knife coater. Among them, a slit die coater or an applicator is preferable, since the film thickness of the obtained wavelength conversion sheet is likely to be homogeneous.

Examples of other coating methods include printing methods such as screen printing, gravure printing, and lithographic printing. Among them, screen printing is preferable from the viewpoint of convenience.

Next, a coating film formed on the support substrate is heated and cured to obtain a wavelength conversion sheet. Heating of the coating film is performed using an instrument such as a natural convection oven, a blast oven, a vacuum oven, an inert oven, a hot plate, a hot press, or an infrared heater. Among them, a blast oven is preferable from the viewpoint of productivity.

As a heating condition of the coating film, for example, a method of heating at 40°C to 250°C for 5 minutes to 100 hours may be used. The heating time is preferably 1 to 30 hours, more preferably 2 to 10 hours, and further preferably 3 to 8 hours. When the heating time is within this range, it is possible to sufficiently remove the solvent and to prevent coloration upon heating.

After applying the wavelength conversion material-containing silicone resin composition on the support substrate, the coating film may be cured by leaving it in an atmosphere at a temperature of 250°C or less, for example, the coating film may be cured by leaving it in an atmosphere at a temperature of 40°C to 200°C. Also, in curing of the coating film, in order to reduce solvents and water that exist in the wavelength conversion material-containing silicone resin composition and to control the condensation reaction rate of the silicone resin A and the silicone oligomer, for example, the coating film may be cured in a stepwise manner, for example, at 40°C to 60°C for 5 minutes to 30 minutes, subsequently at 60°C to 100°C for 10 minutes to 60 minutes, then at 140°C to 200°C for 30 minutes to 5 hours.

As the heating condition of the coating film, by increasing the temperature rise rate when raising the temperature from a low temperature state (for example, room temperature) to a temperature of 120°C, the parameter $d_{Max}$ of the cured product constituting the wavelength conversion sheet can be reduced.

In order to reduce the parameter $d_{Max}$ of the cured product constituting the wavelength conversion sheet, it is preferable to set the rate of temperature rise from 80°C to 120°C to 4°C/min or more.

Further, it is preferable to perform curing at a temperature of 150°C or more for 5 hours or more.

Moreover, the parameter $d_{Max}$ can be reduced by increasing the curing temperature.

Also, in order to control the curing rate, a curing accelerator such as a phosphoric acid-based catalyst or a metallic catalyst may be added to the wavelength conversion material-containing silicone resin composition.

Since the wavelength conversion sheet having such constitution is obtained by molding the above-described cured product of the present embodiment, it has high hardness, high crack resistance and high heat resistance, and has high reliability.

<Light-Emitting Device>

Fig. 3 is a schematic diagram showing the light-emitting device of the present embodiment. The light-emitting

device 100 has the above-described wavelength conversion sheet 30 and a light source 60.

As the light source 60, a known light source such as a mercury lamp or a semiconductor light emitting element can be used. For the light-emitting device of the present embodiment, it is suitable to use a light source that emits high-density energy such as a high luminance LED or a semiconductor laser, or a light source that emits ultraviolet rays of high energy having a wavelength of 400 nm or less or 300 nm or less, such as UV-LED. The light source 60 has a substrate 70 and a light emitting element 80 provided on one surface of the substrate 70.

The wavelength conversion sheet 30 is arranged at a position where light L1 emitted from the light source 60 is made incident.

In such light-emitting device 100, the light L1 emitted from the light source 60 is made incident on the wavelength conversion sheet 30. In the wavelength conversion sheet 30, the filler 50 which is a wavelength conversion material converts the light L1 into converted light L2 having a wavelength different from the light L1. The converted light L2 is emitted from the wavelength conversion sheet 30.

Fig. 4 is a cross-sectional diagram showing a structure of a light-emitting device including the wavelength conversion sheet of the present embodiment.

The light-emitting device 1000 includes a substrate 110, a semiconductor laser element (light source) 120, a light guide portion 130, a wavelength conversion sheet 140, and a reflecting mirror 150. The wavelength conversion sheet 140 having the above-described configuration can be used.

The semiconductor laser element 120 is set on the substrate 110.

In the light guide portion 130, laser light La emitted from the semiconductor laser element 120 is made incident inside, and the laser light La is guided inside. The semiconductor laser element 120 is optically connected to one end of the light guide portion 130, and the wavelength conversion sheet 140 is optically connected to the other end. The light guide portion 130 has a pyramidal shape in which the width gradually decreases from one end side to the other end side, and has a configuration in which the laser light La emitted from the semiconductor laser element 120 is focused on the wavelength conversion sheet 140.

The reflecting mirror 150 is a bowl-shaped member disposed around the wavelength conversion sheet 140, and a curved surface facing the wavelength conversion sheet 140 is a light reflecting surface. The reflecting mirror 150 deflects light emitted from the wavelength conversion sheet 140 in front of the device (irradiation direction of the laser light La).

The laser light La irradiated on the wavelength conversion sheet 140 is converted into white light Lb by the wavelength conversion material contained in the wavelength conversion sheet 140 and output from the light-emitting device 1000.

Although the light-emitting device 1000 has one semiconductor laser element 120, it may have two or more.

Fig. 5 is a cross-sectional diagram showing a modification example of the light-emitting device. In Fig. 5 and the following description, the same reference signs as in Fig. 4 denote the same configurations as those described in Fig. 4.

The light-emitting device 1100 includes a plurality of substrates 110, a plurality of semiconductor laser elements (light sources) 120, a plurality of optical fibers 180, a light guide portion 130, a wavelength conversion sheet 140, a reflecting mirror 150, and a transparent support 190.

In the optical fiber 180, laser light La emitted from the semiconductor laser element 120 is made incident inside, and the laser light La is guided inside. The semiconductor laser element 120 is optically connected to one end of each of the plurality of optical fibers 180. In addition, the plurality of optical fibers 180 are bundled at the other end side, and are optically connected to the light guide portion 130 at the other end in a state of being bundled into one bundle.

In the light guide portion 130, laser light La emitted from the semiconductor laser element 120 is made incident inside, and the laser light La is guided inside and then emitted toward the front of the device. The light guide portion 130 may have a function of converging the laser light La emitted toward the front of the device.

The wavelength conversion sheet 140 is arranged to be opposed to the light guide portion 130 while being separated from the light guide section 130, in a state of being supported by the transparent support 190. The transparent support 190 is provided in front of the device so as to cover an opening portion of the reflecting mirror 150. The transparent support 190 is a member using a transparent material that does not deteriorate due to heat generated during use of the device as a forming material, and for example, a glass plate can be used.

The laser light La irradiated on the wavelength conversion sheet 140 is converted into white light Lb by the wavelength conversion material contained in the wavelength conversion sheet 140 and output from the light-emitting device 1100.

In the light-emitting devices 1000 and 1100, the light source (the semiconductor laser element 120) and the light emitting portion (the wavelength conversion sheet 140) are separated as described above. This facilitates downsizing of the light-emitting device and improvement of designability.

Since the light-emitting device having the constitution as above includes the wavelength conversion sheet of the present embodiment having high hardness, high crack resistance and high heat resistance, it has high reliability.

<Sealing Member, Semiconductor light-emitting device>

Fig. 6 is a cross-sectional diagram of a semiconductor light-emitting device 200 of the present embodiment. The semiconductor light-emitting device of the present embodiment can also be used as the light source of the light-emitting device in Figs. 3 to 5.

The semiconductor light-emitting device 200 includes a substrate 210, a semiconductor light emitting element 220 disposed on the substrate, and a sealing member 230 for sealing the semiconductor light emitting element 220. The sealing member 230 uses the above-described cured product as a forming material. The semiconductor light emitting element 220 is covered and sealed by the substrate 210 and the sealing member 230, and is isolated from outside air.

The cured product constituting the sealing member 230 has high hardness, high crack resistance and high heat resistance as described above. Further, as compared with the sealing part constituted by quartz glass, UV light transmittance is equivalent, the light extraction efficiency is high and it is inexpensive. Therefore, the semiconductor light-emitting device having the sealing member 230 of the present embodiment is hardly damaged and has high reliability.

In addition, since the cured product constituting the sealing member 230 contains the condensed silicone resin cured product as a constituent element, it is hardly deteriorated by UV light. Therefore, in the semiconductor light-emitting device 200 having the sealing member 230 of the present embodiment, even when the semiconductor light emitting element 220 as the light source is a UV light source having an emission wavelength of 400 nm or less, or further 300 nm or less, it is hardly deteriorated and has high reliability.

The semiconductor light emitting element 220 is not limited to one that emits UV light. The emission wavelength of the semiconductor light emitting element 220 may be an ultraviolet range (for example, 10 to 400 nm), a visible light range (for example, more than 400 nm and less than 830 nm), or an infrared range (for example, 830 nm or more and 1000 nm or less).

Since the sealing member having the constitution as above uses the cured product of the present embodiment described above as a forming material, it has high reliability.

Further, since the semiconductor light-emitting device having the constitution as above has the sealing member using the cured product of the present embodiment described above as a forming material, it has high reliability.

Although preferred embodiments of the present invention have been described with reference to drawings 1 to 6, the embodiments of the present invention are not limited to these examples. Various shapes, combinations and the like of the constituent members shown in the above-described examples can be variously changed based on design requirements and the like.

EXAMPLES

Hereinafter, the present invention will be more specifically described with reference to examples, but the present invention is not limited to the following examples.

In the present example, the obtained sample was evaluated or measured by the following method.

<Crack Resistance>

To an aluminum cup with a diameter of 4 cm was added 1.2 g of a silicone resin composition, and it was cured. For the obtained condensed silicone resin cured product, the presence or absence of cracks was visually evaluated.

<Strength>

A test piece with a width of 10 mm, a length of 30 mm, and a thickness of 1 mm was prepared, and a load was applied to the center of the test piece at a speed of 2.0 mm/sec under the following conditions to measure the load and fracture displacement when the test piece broke. The number of tests (number of n) was set to 5, and the arithmetic mean value was taken as the measurement result.

Equipment name: Desktop precision force tester MODEL-1605IIVL
Load cell: MODEL-3000 series
Measurement temperature: 25°C

The average value of the load (bending fracture load, unit N) when the test piece broke was taken as bending strength. A test piece with a bending strength of 20 MPa or more was defined as good.

The average value of fracture displacement (amount of deflection at fracture, unit mm) when the test piece broke was taken as a strain at break. A test piece with a strain at break of 3.0% or more was defined as good.

<Heat Resistance>

A condensed silicone resin cured product (disc shape with a diameter of 4 cm and a thickness of 500 μm) was heated in an oven at 250°C. For the condensed silicone resin cured product before and after heating, light transmittance and appearance (presence or absence of wrinkles and cracks) at a wavelength of 400 nm were evaluated.

<Shore Hardness>

For a condensed silicone resin cured product (disc shape with a diameter of 4 cm and a thickness of 1500 μm), Shore D hardness was measured under the following conditions.

An automatic low pressure loader for durometer (manufactured by TECLOCK Corporation, model number GS-610) equipped with a durometer (manufactured by TECLOCK Corporation, model number GS-720G, Type D) was defined as a measuring device. The durometer is a rubber · plastic hardness tester. Using this measuring device, the Shore D hardness of the condensed silicone resin cured product was measured at a descending speed of 1 mm/sec. The measurement was performed at 5 positions, and the average value was calculated.

A condensed silicone resin cured product having a Shore D hardness of 70 or more was defined as good.

<Transmittance>

A condensed silicone resin cured product with a thickness of 500 μm was prepared. For the obtained condensed silicone resin cured product, the transmittance for light with a wavelength of 400 nm was measured under the following conditions.

Device name: JASCO V-670 Ultraviolet-visible-near-infrared spectrophotometer
Integrating sphere unit (ISN-723/B004861118)
Parameters:

Scanning speed (C): 1000 nm/min
Measurement wavelength: 200 to 800 nm
Data capture interval (L): 1.0 nm

A condensed silicone resin cured product having a transmittance of 90% or more was defined as good.

<Gel Permeation Chromatography (GPC) Measurement>

A measurement solution was prepared by dissolving the sample (silicone resin) in an eluent and then filtering the solution with a membrane filter with a pore size of 0.45 μm. For the obtained preparation solution, the polystyrene equivalent weight average molecular weight (Mw) was measured under the following conditions.

Device name: HLC-8220 GPC manufactured by Tosoh Corporation
Column: TSKgel SuperHM-H × 2 + SuperH2500 × 1 (inner diameter 6.0 mm × 150 mm × 3)
Eluent: toluene
Flow rate: 0.6 mL/min
Detector: RI detector (polarity:-)
Column temperature: 40°C
Injection volume: 40 μL
Molecular weight standard: standard polystyrene

<Solid State $^{29}$Si-NMR>

A condensed silicone resin cured product was prepared, and for the obtained condensed silicone resin cured product, the peak assigned to silicon atoms of a T unit was measured under the following conditions. Specifically, the peak within the region from -80 ppm to -40 ppm was taken as the peak assigned to the silicon atoms of a T unit, and the presence or absence in the above region was confirmed.

Device name: AVANCE300 manufactured by Bruker
Observation nucleus: $^{29}$Si
Observation frequency: 59.6 MHz
Measurement temperature: room temperature
Measurement method: DDMAS method
Reference material: hexamethylcyclotrisiloxane

(Set to -9.66 ppm, equivalent to TMS 0 ppm setting)
MAS condition: 3.5 kHz
Pulse width: n/6 (1.4 μs)
Latency: 20.0 sec
Number of integrations: 4096
Sample amount: 290 mg

<Parameter $d_{Max}$>

A condensed silicone resin cured product with a thickness of 0.5 mm was prepared, and the parameter $d_{Max}$ of the obtained condensed silicone resin cured product was measured.

Measuring apparatus: small-angle X-ray scattering instrument (NanoSTAR, manufactured by Bruker AXS)
Light source: rotating anticathode X-ray generator with a Cu target. Output 50 kV, 100 mA. A cross-coupled Goebel mirror and three pinhole slits are used (slit pore sizes of 500 μmφ, 150 μmφ, 500 μmφ from the X-ray generator side)
Two-dimensional detector: two-dimensional Multi Wire detector, Hi-STAR
Degree of vacuum in the apparatus: 40 Pa
Analysis software: SAXS Ver. 4.1.29 (manufactured by Bruker AXS)

X-rays were irradiated on the condensed silicone resin cured product (sample), and the small-angle X-ray scattering of the condensed silicone resin cured product was measured. The length from the sample to the detector was set to 106 cm, and the size of the direct beam stopper was set to 2 mmφ.

Calibration of a scattering angle 2θ and a direct-beam position was carried out, for example, using respective peaks of a first order (2θ = 1.513°) and a second order (2θ = 3.027°) of silver behenate. The range of measurable scattering angle 2θ was 0.08 to 3°.

The measurement result was analyzed using the analysis software manufactured by Bruker AXS to obtain a small-angle X-ray small-angle scattering spectrum.

Also, a blank measurement (atmospheric scattering) in a state where no sample was installed was also performed in the same manner as described above.

A graph (Kratky Plot) plotting measured values obtained in each measurement was created, with the wavenumber of the X-ray used for measurement of small-angle X-ray scattering of the condensed silicone resin cured product as a horizontal axis, and with the value (spectrum) obtained by multiplying a scattering intensity obtained by subtracting atmospheric scattering from a measured scattering intensity measured by small-angle X-ray scattering of the condensed silicone resin cured product, by the square of the wavenumber (unit: $Å^{-1}$) of the X-ray used for measurement of small-angle X-ray scattering as a vertical axis.

In the Kratky Plot, the parameter $d_{Max}$ was obtained from the following formula (A), from a wavenumber $q_{Max}$ ($Å^{-1}$) of a maximum peak position in the range of wavenumbers of 0.01 $Å^{-1}$ to 0.17 $Å^{-1}$ of X-rays used for measurement of small-angle X-ray scattering.

$$d_{Max} = 2\pi / q_{Max} \quad \ldots (A)$$

[Example 1]

The silicone resin A (Mw = 3500), the low molecular silicone (Mw < 1000) and the alkoxysilicone oligomer (silicone for modification, Mw = 3400) described below are all "condensed silicone resins". The alkoxysilicone oligomer corresponds to the "oligomer B" in the present specification. The low molecular weight silicone corresponds to the "oligomer C" in the present specification.

In the alkoxysilicone oligomer, the sum of areas of the peaks present in a region with a weight average molecular weight of 7500 or more was 20% or more, to the sum of the total areas of the peaks, and the sum of peak areas present in a region with a weight average molecular weight of 1000 or less was 30% or more, to the sum of the total areas of peaks.

The structural units contained in the silicone resin A are shown in Table 1. The structural units contained in the low molecular weight silicone are shown in Table 2. The alkoxysilicone oligomer contained 95% or more of the resin composed of the structural units shown in Table 3.

(Silicone Resin A)

[Table 1]

| Structural unit | 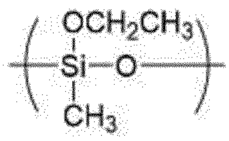 | 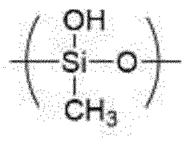 | 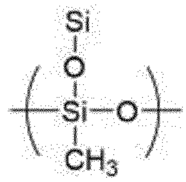 |
|---|---|---|---|
| Abundance ratio | 0.03 | 0.23 | 0.74 |

(Low Molecular Weight Silicone)

[Table 2]

| Structural unit | 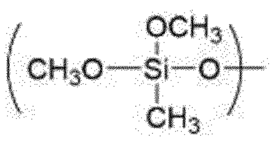 | 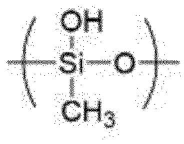 | 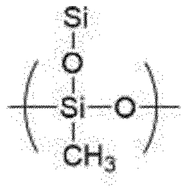 |
|---|---|---|---|
| Abundance ratio | 0.39 | 0.49 | 0.12 |

(Alkoxysilicone Oligomer)

[Table 3]

| Structural unit | 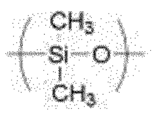 | 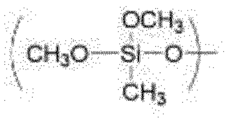 | 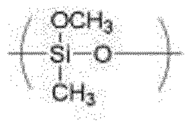 | 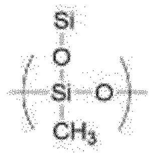 |
|---|---|---|---|---|
| Abundance ratio | 0.20 | 0.10 | 0.45 | 0.25 |

The abundance ratio of the structural units of each condensed silicone resin shown in Tables 1 to 3 is a value calculated based on the measurement result of solution NMR measured under any of the following conditions.

<$^{1}$H-NMR Measurement Conditions>

Device name: ECA-500 manufactured by JEOL RESONANCE Inc.
Observation nucleus: $^{1}$H
Observation frequency: 500.16 MHz
Measurement temperature: room temperature
Measurement solvent: DMSO-$d_6$
Pulse width: 6.60 μsec (45°)
Pulse repetition time: 7.0 sec
Number of integrations: 16
Sample concentration (sample/measurement solvent): 300 mg/0.6 ml

<$^{29}$Si-NMR Measurement Conditions>

Device name: 400-MR manufactured by Agilent Technologies

Observation nucleus: $^{29}Si$
Observation frequency: 79.42 MHz
Measurement temperature: room temperature
Measurement solvent: $CDCl_3$
Pulse width: 8.40 μsec (45°)
Pulse repetition time: 15.0 sec
Number of integrations: 4000
Sample concentration (sample/measurement solvent): 300 mg/0.6 ml

A flask installed in an oil bath was charged with 789.60 g of silicone resin A, 96.00 g of propyl acetate and 314.40 g of isopropyl alcohol, and the mixture was stirred at 80°C to dissolve the silicone resin A in the solvent.

To the obtained solution were added 8.47 g of low molecular silicone and 75.08 g of alkoxysilicone oligomer, and the mixture was stirred for 1 hour or more to dissolve the low molecular silicone and the alkoxysilicone oligomer in the solvent.

To the obtained solution were added 274.49 g of 2-butoxyethyl acetate and 0.22 g of 3-glycidoxypropyltrimethoxysilane (silane coupling agent).

The obtained mixture was set in an evaporator, the temperature of the mixture was set at 85°C and the degree of reduced pressure of the evaporator was set at 2.0 kPa. Then, propyl acetate and isopropyl alcohol were distilled off until the total concentration of propyl acetate and isopropyl alcohol in the mixture became 1% by mass or less.

Two parts by mass of a curing catalyst (containing 15% by mass of phosphoric acid) was added to 100 parts by mass of the obtained mixture, and then the mixture was stirred at a rotation speed of 1800 rpm for 2 minutes using a rotation and revolution mixer (manufactured by THINKY CORPORATION, Awatori Rentaro "ARV-200") to obtain a silicone resin composition.

The obtained silicone resin composition was heated from room temperature to 150°C and held at 150°C for 5 hours to be thermally cured.

Specifically, the temperature was raised from 25°C (room temperature) to 40°C at 3°C/min and held at 40°C for 10 minutes. Thereafter, the temperature was raised to 150°C at 4°C/min and held at 150°C for 5 hours. Thereafter, the mixture was allowed to cool to room temperature over 2 hours to obtain a condensed silicone resin cured product.

In a solid state $^{29}Si$-NMR measurement of the obtained condensed silicone resin cured product, a peak assigned to the silicon atoms of a T unit was confirmed.

To the obtained condensed silicone resin cured product, a Kratky Plot was created by the above-described method. The created Kratky Plot is shown in Fig. 7. In Fig. 7, a horizontal axis Q represents the wavenumber (unit: $Å^{-1}$) of X-rays used for the measurement of small-angle X-ray scattering. The vertical axis $Q^2I$ represents a value obtained by multiplying a scattering intensity (character I) obtained by subtracting atmospheric scattering from a measured scattering intensity measured by small-angle X-ray scattering of the condensed silicone resin cured product, by the square ($Q^2$) of the wavenumber (character Q) of the X-ray used for measurement of small-angle X-ray scattering.

The parameter $d_{Max}$ obtained from Kratky Plot was 150 Å.

The obtained condensed silicone resin cured product had no crack and had good crack resistance.

The obtained condensed silicone resin cured product had a bending strength of 36 MPa, a bending strain of 5.6%, and good strength.

The obtained condensed silicone resin cured product had a Shore D hardness of 73, which was good.

The obtained condensed silicone resin cured product had a transmittance of 92%, which was good.

To the obtained condensed silicone resin cured product, a heat resistance test at 250°C for 100 hours was carried out. No occurrence of wrinkles or cracks was observed in the appearance of the condensed silicone resin cured product after the heat resistance test. In addition, the transmittance of the condensed silicone resin cured product after the heat resistance test was 92%, thus transparency was maintained.

To the obtained condensed silicone resin cured product, a heat resistance test at 250°C for 1000 hours was carried out. No occurrence of wrinkles or cracks was observed in the appearance of the condensed silicone resin cured product after the heat resistance test. In addition, the transmittance of the condensed silicone resin cured product after the heat resistance test was 92%, thus transparency was maintained.

[Example 2]

A condensed silicone resin cured product was obtained in the same manner as in Example 1, except that the thermal curing conditions of the silicone resin composition in Example 1 were changed to the following conditions.

"The obtained silicone resin composition was heated from room temperature to 200°C and held at 200°C for 5 hours to be thermally cured.

Specifically, the temperature was raised from 25°C (room temperature) to 40°C at 3°C/min and held at 40°C for 10 minutes. Thereafter, the temperature was raised to 200°C at 4°C/min and held at 200°C for 5 hours. Thereafter,

the mixture was allowed to cool to room temperature over 2 hours to obtain a condensed silicone resin cured product."

In a solid state $^{29}Si$-NMR measurement of the obtained condensed silicone resin cured product, a peak assigned to the silicon atoms of a T unit was confirmed.

To the obtained condensed silicone resin cured product, a Kratky Plot was created by the above-described method. The parameter $d_{Max}$ obtained from Kratky Plot was 105 Å.

The obtained condensed silicone resin cured product had no crack and had good crack resistance.

The obtained condensed silicone resin cured product had a bending strength of 24 MPa, a bending strain of 3.8%, and good bending strength.

The obtained condensed silicone resin cured product had a Shore D hardness of 73, which was good.

The obtained condensed silicone resin cured product had a transmittance of 92%, which was good.

To the obtained condensed silicone resin cured product, a heat resistance test at 250°C for 100 hours was carried out. No occurrence of wrinkles or cracks was observed in appearance. In addition, the transmittance was 92%, thus transparency was maintained.

[Comparative Example 1]

The structural units contained in the silicone resin B (Mw = 3500) described below are shown in Table 4. The abundance ratio of the structural units of the silicone resin B shown in Table 4 is a value calculated based on the measurement result of solution NMR described above. The silicone resin B corresponds to the "condensed silicone resin" in the present specification.

(Silicone Resin B)

[Table 4]

| Structural unit | 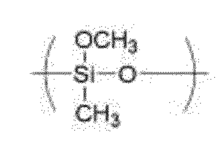 | 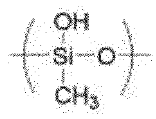 | 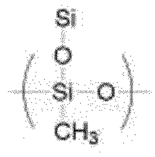 |
|---|---|---|---|
| Abundance ratio | 0.08 | 0.15 | 0.77 |

Seventy-five parts by mass of the alkoxysilicone oligomer shown in Table 3 above and 25 parts by mass of the silicone resin (MW = 3500) having a repeating unit in the abundance ratio shown in Table 4 above were mixed, further, 2 parts by mass of the curing catalyst same as that used in Example 1 was added thereto, and the mixture was sufficiently stirred and mixed using a rotation and revolution mixer (manufactured by THINKY CORPORATION, Awatori Rentaro "ARV-200") to obtain a silicone resin composition.

The obtained silicone resin composition was thermally cured in the same manner as the thermal curing conditions of the silicone resin composition in Example 1 to obtain a condensed silicone resin cured product.

In a solid state $^{29}Si$-NMR measurement of the obtained condensed silicone resin cured product, a peak assigned to the silicon atoms of a T unit was confirmed.

To the obtained condensed silicone resin cured product, a Kratky Plot was created by the above-described method. The created Kratky Plot is shown in Fig. 7. The parameter $d_{Max}$ obtained from Kratky Plot was 195 Å.

The obtained condensed silicone resin cured product had no crack and had good crack resistance.

For the obtained condensed silicone resin cured product, while measurement of Shore D hardness was attempted, it was impossible to measure due to insufficient strength of the condensed silicone resin cured product. The Shore A hardness of the obtained condensed silicone resin cured product was measured and found to be 87.

[Comparative Example 2]

Eighty parts by mass of the silicone resin shown in Table 4 above and 20 parts by mass of 2-butoxyethyl acetate were stirred and mixed to obtain a silicone resin composition.

The obtained silicone resin composition was thermally cured in the same manner as the thermal curing conditions of the silicone resin composition in Example 1 to obtain a condensed silicone resin cured product.

In a solid state $^{29}Si$-NMR measurement of the obtained condensed silicone resin cured product, a peak assigned

to the silicon atoms of a T unit was confirmed.

To the obtained condensed silicone resin cured product, a Kratky Plot was created by the above-described method. The created Kratky Plot is shown in Fig. 7. In the created Kratky Plot, no maximum peak was observed within the range of 0.01 $Å^{-1}$ to 0.17 $Å^{-1}$.

The obtained condensed silicone resin cured product had a crack and poor crack resistance.

The obtained condensed silicone resin cured product did not have measurable bending strength, Shore D hardness, and transmittance.

[Comparative Example 3]

The following silicone resin C (Mw = 2100) has a structure represented by the following formula. The silicone resin C is the "condensed silicone resin" in the present specification.

(Silicone Resin C)

[Chemical Formula 6]

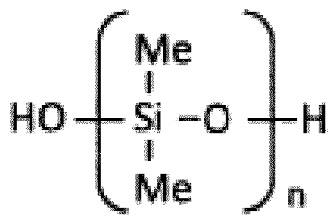

A flask was charged with 60.0 g of the silicone resin shown in Table 4, 32.3 g of isopropyl alcohol and further 40.0 g of a silicone resin (weight average molecular weight = 2100) represented by the following formula, and the mixture was stirred for 1 hour to dissolve the silicone resins.

Thereafter, 6.4 g of 2-butoxyethyl acetate was added thereto, the mixture was allowed to stand under conditions of 80°C and 4 kPa by an evaporator, and isopropyl alcohol was distilled off until the isopropyl alcohol concentration became 1% by mass or less.

To the obtained mixture was added 2% by mass of a curing catalyst (containing 15% by mass of phosphoric acid), then the mixture was sufficiently stirred and mixed to obtain a silicone resin composition.

The obtained silicone resin composition was heated from room temperature to 150°C and held at 150°C for 5 hours to be thermally cured.

Specifically, the temperature was raised from 25°C (room temperature) to 40°C at 3°C/min and held at 40°C for 10 minutes. Thereafter, the temperature was raised to 150°C at 1.8°C/min and held at 150°C for 5 hours. Thereafter, the temperature was lowered to room temperature at 2°C/min to obtain a condensed silicone resin cured product.

In the solid state $^{29}$Si-NMR measurement of the obtained cured product, a peak assigned to the silicon atoms of a T unit was confirmed.

To the obtained condensed silicone resin cured product, a Kratky Plot was created by the above-described method, and no maximum peak was observed within the range of 0.01 $Å^{-1}$ to 0.17 $Å^{-1}$.

The obtained condensed silicone resin cured product had a Shore D hardness of 37, which was poor.

Based on the above, it was found that the cured product of the present invention is useful.

INDUSTRIAL APPLICABILITY

According to the present invention, it is possible to provide a cured product having high hardness, high crack resistance and high heat resistance. Further, it is possible to provide a wavelength conversion sheet using the cured product as a forming material, a light-emitting device, a sealing member, and a semiconductor light-emitting device.

DESCRIPTION OF REFERENCE SIGNS

| | |
|---|---|
| 10... | Silicone resin |
| 30... | Wavelength conversion sheet |
| 40... | Polymer |
| 50... | Filler |
| 60... | Light source |
| 70... | Substrate |
| 80... | Light emitting element |
| 100, 1000, 1100... | Light-emitting device |
| 110... | Substrate |
| 120... | Semiconductor laser element (light source) |
| 130... | Light guide portion |
| 140... | Wavelength conversion sheet |
| 150... | Reflecting mirror |
| 160... | Laser light |
| 170... | White light |
| 180... | Optical fiber |
| 190... | Transparent support |
| 200... | Semiconductor light-emitting device |
| 210... | Substrate |
| 220... | Semiconductor light emitting element |
| 230... | Sealing member 230 |
| L1... | Light |
| L2... | Converted light |

**Claims**

**1.** A cured product comprising a condensed silicone resin cured product and satisfying the following (1) and (2) :

(1) In a solid state $^{29}$Si-nuclear magnetic resonance spectrum of the condensed silicone resin cured product, there is a peak assigned to silicon atoms of a T unit, wherein the silicon atoms of a T unit mean silicon atoms bonded to three oxygen atoms.
(2) In the following Kratky Plot, from a wavenumber $q_{Max}$ ($Å^{-1}$) of a maximum peak position in the range of wavenumbers of 0.01 $Å^{-1}$ to 0.17 $Å^{-1}$ of X-rays used for measurement of small-angle X-ray scattering, a parameter $d_{Max}$ obtained by the following formula (A) is 170 Å or less.

$$d_{Max} = 2\pi/q_{Max} \quad ...(A)$$

wherein the Kratky Plot means,a graph obtained by plotting measured values of small-angle X-ray scattering of the condensed silicone resin cured product,
with the wavenumber of the X-ray used for measurement of small-angle X-ray scattering as a horizontal axis, and with the value obtained by multiplying a scattering intensity obtained by subtracting atmospheric scattering from a measured scattering intensity to be measured by small-angle X-ray scattering, by the square of the wavenumber (unit: $Å^{-1}$) of the X-ray used for measurement of small-angle X-ray scattering as a vertical axis.

**2.** The cured product according to claim 1, wherein the ratio of the silicon atoms of the T unit to all silicon atoms contained in the condensed silicone resin cured product is 50% by mole or more.

**3.** The cured product according to claim 2, wherein the ratio of the T3 silicon atoms to all silicon atoms contained in the condensed silicone resin cured product is 50% by mole or more,
wherein the T3 silicon atoms mean silicon atoms in which all three oxygen atoms are bonded to other silicon atoms, among the silicon atoms of the T unit.

**4.** The cured product according to any one of claims 1 to 3, wherein the condensed silicone resin cured product comprises a structural unit represented by formula (A1), formula (A1'), formula (A2) or formula (A3),

[Chemical Formula 1]

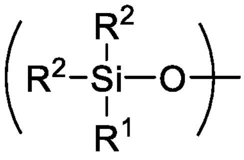 (A1) 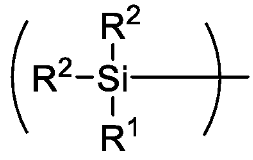 (A1')

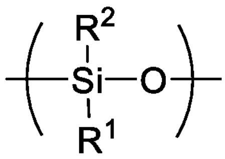 (A2) 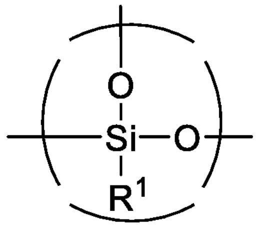 (A3)

in the formulas (A1), (A1'), (A2) and (A3),

$R^1$s represent alkyl groups having 1 to 10 carbon atoms or aryl groups having 6 to 10 carbon atoms;
$R^2$s represent alkoxy groups having 1 to 4 carbon atoms or hydroxyl groups; and
a plurality of $R^1$s and $R^2$s each may be the same or different.

**5.** The cured product according to claim 4, wherein the $R^1$s are methyl groups, and the $R^2$s are alkoxy groups having 1 to 3 carbon atoms or hydroxyl groups, and a plurality of $R^2$s may be the same or different.

**6.** The cured product according to any one of claims 1 to 5, wherein a filler is dispersed in the condensed silicone resin cured product.

**7.** The cured product according to claim 6, wherein the filler is a wavelength conversion material.

**8.** The cured product according to claim 7, wherein the wavelength conversion material is a phosphor.

**9.** A wavelength conversion sheet comprising the cured product as defined in claim 7 or 8 as a forming material.

**10.** A light-emitting device having a light source for emitting light, and the wavelength conversion sheet as defined in claim 9 arranged at a position where light emitted from the light source is made incident.

**11.** A sealing member using the cured product as defined in any one of claims 1 to 8 as a forming material.

**12.** A semiconductor light-emitting device having a substrate,
a semiconductor light emitting element disposed on the substrate, and
a sealing member for sealing at least a part of the semiconductor light emitting element, wherein
the sealing member is the sealing member as defined in claim 11.

**13.** The semiconductor light-emitting device according to claim 12, wherein the emission wavelength of the semiconductor light emitting element is 400 nm or less.

Fig.1

(a)

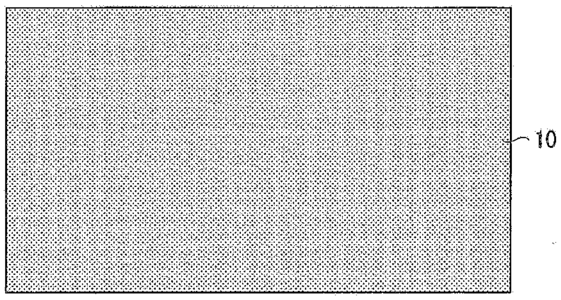


(b)

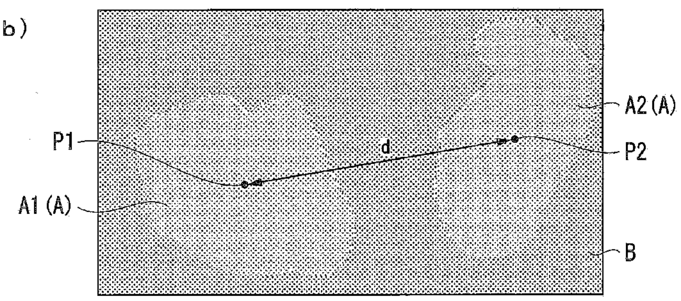


Fig.2

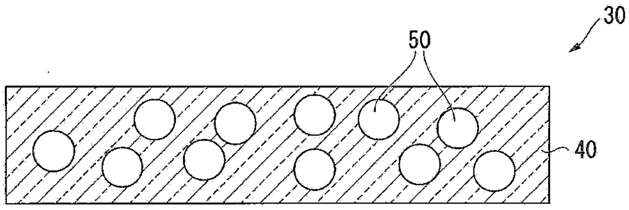

Fig.3

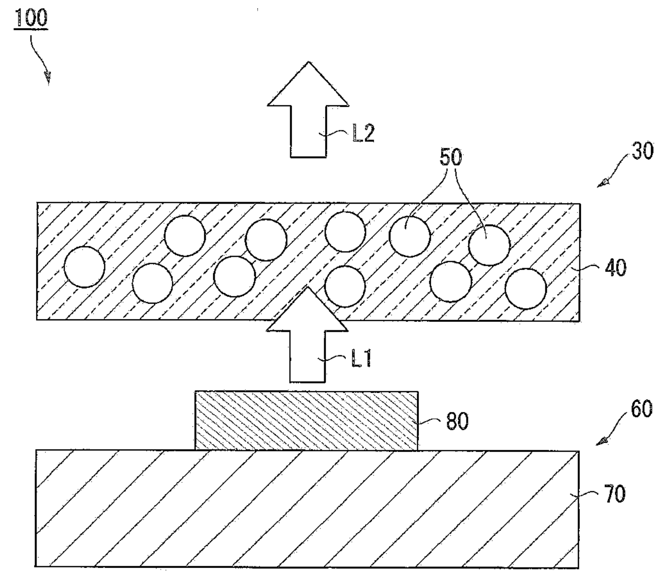


Fig.4

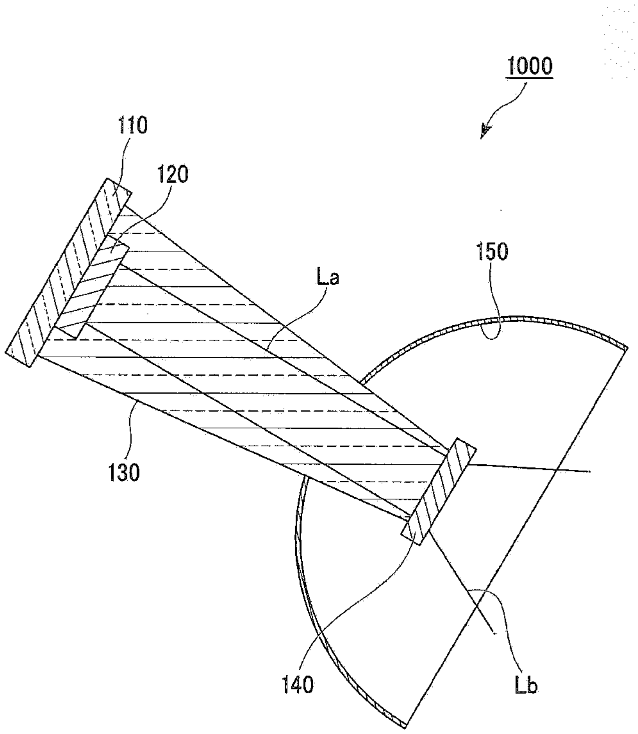

Fig.5

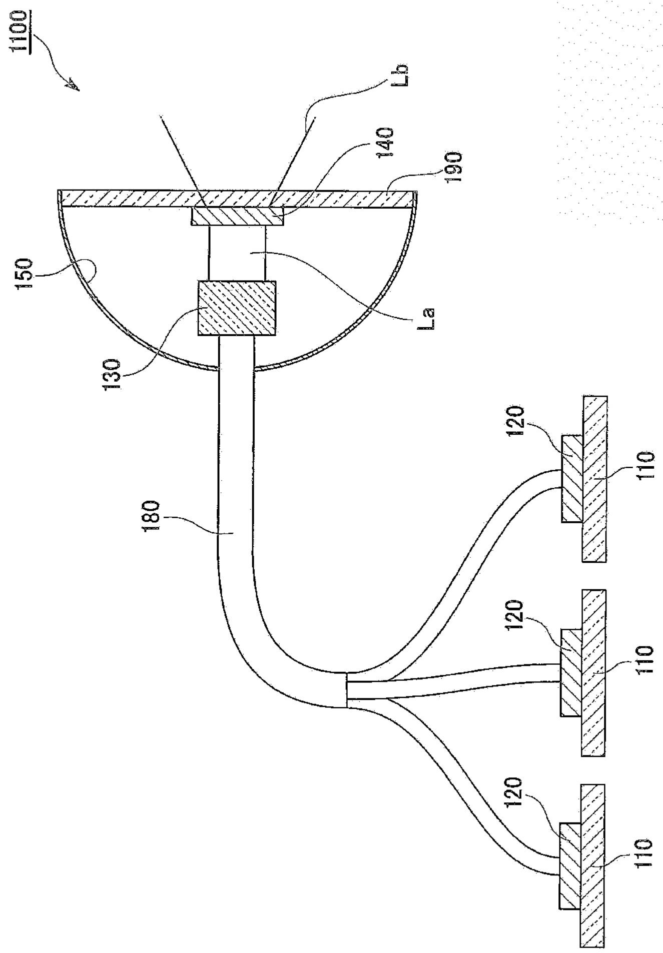
1100
Lb
140
190
150
La
130
180
120
110
120
110
120
110

Fig.6

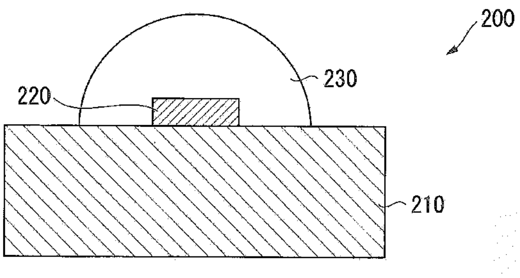
200
230
220
210

Fig.7

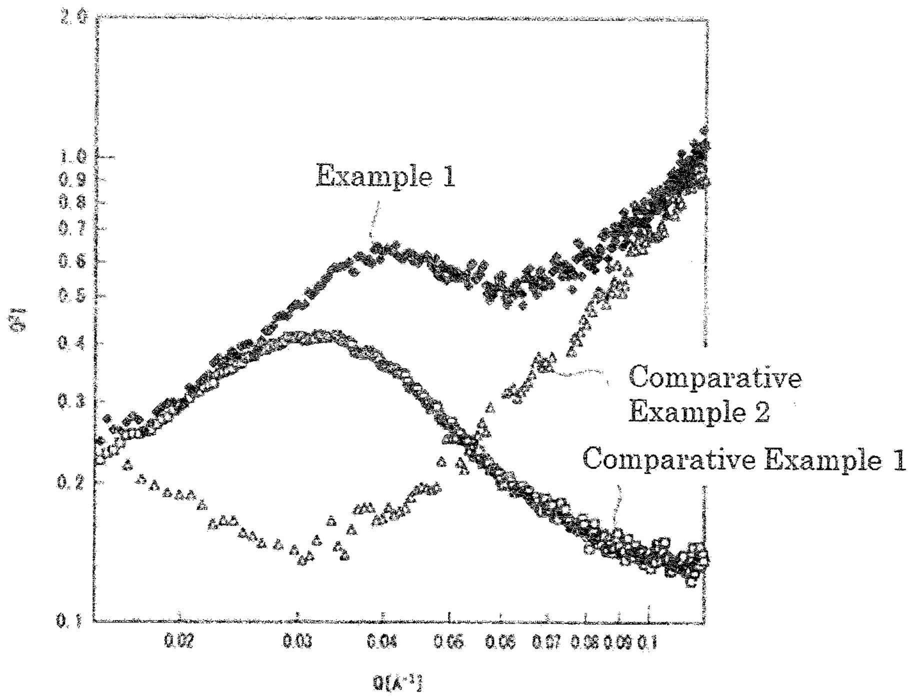
Example 1
Comparative Example 2
Comparative Example 1
2.0
1.0
0.9
0.8
0.7
0.6
0.5
0.4
0.3
0.2
0.1
0.02
0.03
0.04
0.05
0.06
0.07
0.08
0.09
0.1

**INTERNATIONAL SEARCH REPORT**

International application No. PCT/JP2017/031731

A. CLASSIFICATION OF SUBJECT MATTER

*C08G77/04*(2006.01)i, *C08G77/44*(2006.01)i, *C08K3/00*(2006.01)i, *C08L83/04*(2006.01)i, *C08L83/06*(2006.01)i, *H01L23/29*(2006.01)i, *H01L23/31*(2006.01)i, *H01L33/50*(2010.01)i, *H01L33/56*(2010.01)i, *H01S5/022*(2006.01)i

According to International Patent Classification (IPC) or to both national classification and IPC

B. FIELDS SEARCHED

Minimum documentation searched (classification system followed by classification symbols)

C08G77/00-77/62, C08K3/00-3/40, C08L83/00-83/16, H01L23/00-23/56, H01L33/00-33/64, H01S5/00-5/50

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)

JSTPlus/JMEDPlus/JST7580(JDreamIII)

C. DOCUMENTS CONSIDERED TO BE RELEVANT

| Category* | Citation of document, with indication, where appropriate, of the relevant passages | Relevant to claim No. |
|---|---|---|
| X | WO 2016/17592 A1 (Sumitomo Chemical Co., Ltd.), 04 February 2016 (04.02.2016), claims 1 to 12; paragraphs [0001], [0007], [0018], [0052], [0059], [0063], [0070], [0101], [0102], [0118]; examples & US 2017/0210899 A1 claims; examples & EP 3176238 A1 & KR 10-2017-0037954 A & CN 106661425 A & TW 201617430 A | 1-13 |
| A | JP 2015-89898 A (Shin-Etsu Chemical Co., Ltd.), 11 May 2015 (11.05.2015), entire text & WO 2015/068338 A1 & TW 201530823 A | 1-13 |

☒ Further documents are listed in the continuation of Box C. ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| 05 October 2017 (05.10.17) | 17 October 2017 (17.10.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2017/031731

C (Continuation). DOCUMENTS CONSIDERED TO BE RELEVANT

| Category* | Citation of document, with indication, where appropriate, of the relevant passages | Relevant to claim No. |
|---|---|---|
| A | JP 2014-221880 A (Shin-Etsu Chemical Co., Ltd.), 27 November 2014 (27.11.2014), entire text & US 2014/0339473 A1 entire text & CN 104151834 A & KR 10-2014-0134611 A & TW 201512291 A | 1-13 |
| A | JP 2010-126596 A (Showa Denko Kabushiki Kaisha), 10 June 2010 (10.06.2010), entire text (Family: none) | 1-13 |
| A | JP 2010-209259 A (Sumitomo Chemical Co., Ltd.), 24 September 2010 (24.09.2010), entire text (Family: none) | 1-13 |
| A | JP 10-231363 A (Mitsubishi Chemical Corp.), 02 September 1998 (02.09.1998), entire text & US 6291697 B1 entire text & WO 1997/035908 A1 & EP 890597 A1 & KR 10-2000-0004954 A | 1-13 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013001792 A